# EUROPÄISCHE PATENTANMELDUNG

(11) **EP 4 703 107 A2**
(43) Veröffentlichungstag der Anmeldung: **04.03.2026**
(21) Anmeldenummer: 25198162.7
(22) Anmeldetag: 26.08.2025
(51) Int. Cl.: B28B 1/00, B28B 17/00, B28B 23/00, B33Y 10/00, B33Y 80/00, E04C 1/39, E04G 21/04, G06F 30/13, E04B 2/18, E04B 2/50, E04G 21/22

(54) **VERFAHREN ZUR HERSTELLUNG EINER WAND, BAUELEMENT ZUM AUFBAU EINER WAND, BAUELEMENTSATZ UND GEBÄUDEROHBAU**

(30) Priorität: 29.08.2024 DE 102024124661
(71) Anmelder: Bundesanstalt für Materialforschung und -Prüfung (BAM), 12205 Berlin (DE)
(72) Erfinder: GÜNSTER, Jens, Prof. Dr., 38678 Clausthal-Zellerfeld (DE)
(74) Vertreter: Zimmermann & Partner Patentanwälte mbB

(57) **Zusammenfassung**

Verfahren (1000) zur Herstellung einer Wand (200, 300, 3000a), aufweisend: computergestütztes Konstruieren (1010) der Wand (200, 300, 300a), wobei die Wand (200, 300, 300a) einen Installationskanal (1) aufweist; computergestütztes Zerlegen (1020) der konstruierten Wand (200, 300, 300a) in Bauelemente (100, 110, 120, 130, 140, 150, 160), wobei eine Vielzahl zueinander benachbarter Bauelemente (100, 110, 120, 130, 140, 150, 160) zumindest einen Abschnitt des Installationskanals (1) umfasst; computergestütztes Erstellen (1030) eines Steuerdatensatzes zur Steuerung einer Vorrichtung (500) zur additiven Fertigung, die konfiguriert ist, aus zumindest einem Baustoff die Vielzahl der Bauelemente (100, 110, 120, 130, 140, 150, 160) individuell bereitzustellen; additives Fertigen (1040) der Vielzahl der Bauelemente (100, 110, 120, 130, 140, 150, 160) für die Wand (200, 300, 300a) mit der Vorrichtung (500) zur additiven Fertigung unter Verwendung des Steuerdatensatzes; und typischerweise Errichten der Wand (1100) durch ein geordnetes Fügen der Vielzahl der gefertigten Bauelemente (100, 110, 120, 130, 140, 150, 160) umfassend ein Ausbilden eines Verbandes (200, 300, 300a) der Bauelemente 100, 110, 120, 130, 140, 150, 160).

## Beschreibung

Die Erfindung liegt auf dem Gebiet der Bauindustrie und des Ingenieurbaus, insbesondere der Anwendung additiver Fertigungsverfahren zur Errichtung von Bauwerken im Bereich Wohnungs-, Industrie-, Gewerbe-, Verwaltungs- und Landwirtschaftsbau. Das vorgeschlagene Verfahren ist ebenso der Gebäudeausrüstung und Versorgungstechnik zuzuordnen, die bekanntermaßen alle für die Nutzbarmachung von Gebäuden notwendigen Maßnahmen umfasst.

### Vorbekannter Stand der Technik

Beim Bau eines Hauses kleiner oder mittlerer Größe, wie z.B. eines Einfamilienhauses, wird zunächst ein Rohbau gefertigt, der anschließend mit der erforderlichen Infrastruktur, wie beispielsweise Elektrik, Wasser/Abwasser, Klima und/oder Heizung, ausgerüstet wird. Hierbei wird ein Teil des in Form des Rohbaus aufgestellten Materials wieder entfernt, um Platz für die Installation von Kabeln, Leitungen, Luftzuführungen etc. zu schaffen.

### Nachteile des Standes der Technik

Die beschriebene Vorgehensweise ist arbeits- und zeitaufwendig und führt beim Einbringen von Kabelkanälen, Mauerdurchbrüchen etc. zu unnötiger Belastung durch Staub, Schutt und Lärm. Das nachträgliche Fräsen von Kabelkanälen in bereits fertige Wände für unter-Putz-Leitungen oder die Abdeckung von Rohrleitungen durch Sichtschutzplatten kann kaum als resoucenschonend gelten. Ausnehmungen und Kanäle in der Wand, bzw. letztlich in den Bausteinen der Wand dienen im weitesten Sinne der Versorgungstechnik. Nachfolgend werden sie zusammenfassend als Installationskanäle bezeichnet.

### Problemstellung

Vor diesem Hintergrund ist es eine Aufgabe der vorliegenden Erfindung, ein Verfahren, hier auch als Prozesskette bezeichnet, zum Bau eines vollwertig nutzbaren Bauwerks, beispielsweise eines Wohnhauses, oder eines anderen Bauwerks, beispielsweise eines Gartenhäuschens, einer Stallung, einer Trafostation, eines Wartehäuschens, einer Verteilerstation, einer Schutzwand etc. bereitzustellen, das die genannten Nachteile vermeidet.

Es ist eine weitere Aufgabe der vorliegenden Erfindung, die Installation und Inbetriebnahme der beschriebenen technischen Infrastruktur bzw. der Versorgungstechnik für das entsprechende Bauwerk, die Gegenstand der sogenannten technischen Gebäudeausrüstung ist, mit einem wesentlich verringerten Arbeitsaufwand und somit geringeren Kosten als für herkömmliche Verfahren zu ermöglichen.

### Erfindungsgemäße Lösung

Eine Lösung dieser Aufgabe wird ermöglicht durch das hier vorgeschlagene Verfahren einer additiven Fertigung individueller Bauelemente einer Wand, aus denen die Wand errichtet werden kann. Das vorgeschlagene Verfahren wird nachfolgend mit Prozessschritten beschrieben, die zur Fertigung einer Wand, als elementarem Bestandteil der oben angeführten Bauten, geeignet sind. Die Bauelemente können als multifunktionale Bausteine, bzw. als Bausatz, der solche Bausteine umfasst, aufgefasst werden. Ein entsprechender Bausatz ist somit angepasst zur Errichtung eines Bauwerks das zumindest einen Installationskanal umfasst oder zumindest angepasst zur Errichtung einer Wand, die einen Installationskanal umfasst.

Nachfolgend werden die Bauelemente des Bausatzes vereinfachend auch als Bausteine bezeichnet. Die Begriffe "Bauelement" und "Baustein" werden im nachfolgenden Text und den zugehörigen Ansprüchen als Synonyme behandelt: Ein "Baustein", der zum Aufbau eines Bauwerks oder Teilen davon wie einer Wand, bspw. auch einer tragenden Wand geeignet ist, muss bekanntermaßen nicht aus Stein bestehen und muss auch nicht die traditionelle Quader-Form eines Ziegelsteins haben. Wie beispielsweise an Hand der Mauern von Machu Pichu, eines 2D-Puzzle, eines Geometrie-Puzzle, des Videospiel "Tetris", oder gar eines 3D-Puzzle belegbar, kann ein "Baustein" durchaus auch unterschiedliche Konturen und Formen aufweisen, die von der Form eines Rechtecks bzw. der eines Quaders abweichen, und trotzdem zu einer vollflächig geschlossenen Struktur führen.

Typischerweise lässt sich eine äußere Form der hierin beschriebenen Bauelemente beschreiben als letztendlich rückführbar auf im Wesentlichen quaderförmige Grundelemente. Die Vielzahl der vorgeschlagenen Bauelemente sind mithin nicht zwingend ziegelförmig, sondern in einer flächigen Projektion ihrer Seitenansicht, wie beispielsweise beim Computerspiel "Tetris" oder bei bestimmten Arten von 3d-Puzzles im verbauten Zustand auch als T, 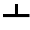 , **└, ┐,** ┌, E, 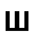 , ∃, oder **F**- förmig erscheinende Bauelemente anzusehen. Die erfindungsgemäß vorgeschlagenen Bauelemente können mithin von ihrer äußeren Form her vergleichbar zu 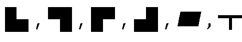 , ┴,+, ├, ┤, 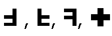 , usw. -förmigen "Bauklötzen" sein, wobei die vorstehend angeführten Beispiele nur eine Projektion dreidimensionaler Steine auf eine zweidimensionale Fläche darstellen. Es ist aber auch möglich, dass die hierin beschriebenen Bauelemente gekrümmte (äußere) Oberflächen (Mantelflächen) aufweisen, z.B. wie ein Hohlzylindersegment oder wie ein gebogener Balken geformt sein. Abgesehen von etwaigen Hohlräumen/Durchführungen für einen oder mehrere Installationskanäle oder Abschnitte davon entspricht die Form der hierin beschriebenen Bauelemente typischerweise also einem Extrusionskörper (im geometrischen Sinn, allgemeiner Zylinder im mathematischen Sinn), dessen ebene Grundfläche von einer (äußeren) Kontur wie einem Rechteck oder einem anderen Polygon umgeben oder sogar definiert ist. Die (äußere) Kontur kann aber auch gekrümmte Abschnitte aufweisen oder aus diesen bestehen, insbesondere auch solche, die sich nicht mittels Extrusion herstellen lassen. Dies gilt auch für eine oder mehrere optionale innere Konturen. Die folgende Beschreibung bezieht sich auch aus Gründen der besseren Lesbarkeit häufig auf die ohnehin oft verwendeten, im Wesentlichen quaderförmige Bauelemente.

Typischerweise ist nur die eingangs bezeichnete "Vielzahl Bauelemente" an der Ausbildung eines Installationskanals der Wand beteiligt. Ebenso werden typischerweise Bauelemente gemäß dem vorgeschlagenen Verfahren gefertigt, die keinen Abschnitt des Installationskanals beinhalten. Eine verfahrensmäßig konstruierte Wand, also die mit den verfahrensgemäß hergestellten Bauelementen aufgebaute Wand, ist typischerweise zumindest 1 m breit und 1 m hoch, bevorzugt mindestens 2,50 - 2,80 m hoch.

Die individuellen, zumindest teilweise multifunktionalen, d.h. einen Installationskanalabschnitt umfassenden, Bausteine sind konfiguriert für den Aufbau einer funktionalen Gesamtstruktur, beispielsweise einer freistehenden Wand oder eines Bauwerks, das mehrere Wände aufweist. Die Wände können sowohl als tragende Wände, als auch als nichttragende Wände, z.B. als Trennwände oder Schutzwände dienen. Somit ist jeder der additiv gefertigten individuellen Bausteine ein Bestandteil der jeweiligen funktionalen Gesamtstruktur.

Insbesondere wird die beschriebene Aufgabe gelöst mit dem offenbarten Herstellungsverfahren einer Wand, die eine Vielzahl von strukturell und funktional aufeinander abgestimmten Bausteinen bzw. Bauelementen aufweist. Die Vielzahl der Bausteine, also die Vielzahl der Bauelemente, der Wand ist konfiguriert hinsichtlich ihrer Masterialzusammensetzung, ihrer Form und letzlich ihrer Tragfestigkeit (Endfestigkeit) zur Errichtung eines Bauwerks, beispielsweise eines Gebäudes. Das vorgeschlagene Verfahren umfasst den Entwurf und/oder die Planung, typischerweise eine computergestützte Planung, des Bauwerks nach architektonischen, optional auch nach innenarchitektonischen, Gesichtspunkten. Im Unterschied zu vorbekannten Verfahren umfasst das vorgeschlagene Verfahren wesentliche Aspekte der jeweils projektierten technischen Versorgungsstrukturen bzw. der entsprechenden Gebäudeausrüstung. Die Begriffe technische Gebäudeausrüstung und Versorgungsstruktur bzw. Versorgungstechnik beschreiben hierbei technische Maßnahmen, die in Gebäuden einer energetischen Versorgung (Beheizung, Kühlung und Beleuchtung), einer stofflichen Versorgung (Wasserversorgung, Belüftung) und/oder einer stofflichen Entsorgung dienen. Im Ergebnis der technischen Gebäudeausrüstung wird das Gebäude für die Nutzer/Bewohner nicht nur nutzbar oder bewohnbar, sondern gewährleistet optional auch die Erfüllung von Sicherheitsaufgaben. Beispiele von Sicherheitsaufgaben können Vorrichtungen oder Bestandteile einer Alarm- und Sicherheitstechnik, z.B. Einbruchsschutz- und Brandschutztechnik umfassen. Das hier vorgeschlagene Verfahren eröffnet mit dem Bereitstellen eines vollständigen Satzes von Bauelementen zur Fertigstellung des Gebäudes Vorteile für die Fachgebiete bzw. Gewerke Elektrotechnik, Gebäudeautomation, Raumluft-, Sanitär-, Wärme-, Heiz-, Kälte- und Kühltechnik.

Gemäß verschiedener Ausführungsformen weist zumindest eine Vielzahl der vorgeschlagenen Bausteine Installationsknäle bzw. Abschnitte eines Installationskanals zur Führung von Flüssigkeiten, beispielsweise Trink-, Brauch- und Abwasser auf. Gemäß dieser und weiterer Ausführungsformen oder zusätzlich kann die Führung von Gasen, insbesondere von Luft, in den miteinander in einem Verband - der Wand - angeordneten Bauelementen verwirklicht werden. Mögliche Anwendungen sind beispielsweise Systeme, die der Belüftung, der Entlüftung und/oder der Klimatisierung dienen. Die vorgeschlagene Prozesskette zur Herstellung der Wand umfasst weiterhin die additive Fertigung einer zur Errichtung der projektierten Wand und/oder eines projektierten Gebäudes benötigten Vielzahl von Bausteinen, sowie optional letztendlich deren stoff- und/oder formschlüssiges Fügen bzw. deren Verbau zu einem Mauersteinverband, der Bestandteil eines Bauwerks, beispielsweise eines Gebäudes, sein kann.
(1) Gemäß einer Ausführungsform wird ein Verfahren zur Herstellung einer Wand vorgeschlagen, dass die folgenden Prozessschritte umfasst:
   - computergestütztes Konstruieren, umfassend oder gleichbedeutend mit einer Baukonstruktion, einem Entwerfen, einem Projektieren bzw. einem Design der Wand, wobei die Wand einen Installationskanal und optional zusätzlich eine Öffnung aufweist, ausgewählt aus einer Türöffnung und einer Fensteröffnung;
   - computergestütztes Zerlegen der konstruierten Wand in virtuelle Bauelemente,
      wobei eine Vielzahl zueinander benachbarter virtueller Bauelemente zumindest einen Abschnitt des Installationskanals und/oder optional einen Abschnitt einer der vorstehend genannten Öffnungen umfasst;
   - computergestütztes Erstellen eines Steuerdatensatzes zur Steuerung einer Vorrichtung zur additiven Fertigung, die konfiguriert ist, im Ergebnis eines Fertigungszyklus zumindest die Vielzahl der individuellen Bauelemente individuell bereitzustellen; und
   - additives Fertigen der Vielzahl der individuellen Bauelemente für die Wand mit der Vorrichtung zur additiven Fertigung unter Verwendung des Steuerdatensatzes; und typischerweise
   - Errichten der Wand durch ein geordnetes Fügen der Vielzahl der gefertigten Bauelemente umfassend ein Ausbilden eines Verbandes der Bauelemente.

Der vorstehend benannte Steuerdatensatz umfasst typischerweise CAD-CAM-Daten, beispielsweise in Form eines STL-files. Der Steuerdatensatz ist eingerichtet, die Funktionen einer Vorrichtung zur additiven Fertigung zu steuern, beispielsweise einen Druckkopf eines 3D-Druckers zu steuern, oder das Zusammenwirken des Druckkopfes mit einem Laser der Vorrichtung zu steuern; und/oder ein zielgerichtetes Zusammenwirken eines Lasers und/oder eines Druckkopfes mit einer Rakel der Vorrichtung zu steuern. Im Ergebnis der bezeichneten Steuervorgänge ist zumindest die Vielzahl der zueinander benachbarten Bauelemente der projektierten Wand individuell additiv herstellbar. Der Steuerdatensatz umfasst dazu eine entsprechende Vielzahl von Steuerdaten, die jeweils spezifisch exakt einem Bauelement aus der Vielzahl virtueller Bauelemente und so letztlich der Vielzahl körperlich zu fertigender Bauelemente entsprechen, bzw. zu deren additiver Fertigung erforderlich sind und während des Fertigens verwendet werden.

Umfasst die bezeichnete Vorrichtung einen 3D-Drucker, so kann der zum Druck verwendete Baustoff beispielsweise in Form eines Filaments vorliegen. Das Filament wird vom Druckkopf plastifiziert, an- und/oder aufgeschmolzen und beispielsweise auf einer Arbeitsplattform angeordnet und schrittweise bzw. schichtweise aufgetragen, bis das Bauelement oder ein Rohling desselben vollständig ausgebildet ist.

Wenn die bezeichnete Vorrichtung eine Rakel sowie einen Laser und/oder einen Druckkopf aufweist, so kann der verarbeitete Baustoff in Form eines trockenen Pulvers oder in Form eines suspendierten Pulvers als Schlicker oder als Paste vorliegen. Das trockene Pulver, der Schlicker und die Paste werden mit der Rakel oder einem ihr entsprechenden Element, beispielsweise einer Walze oder einer, ggf. auch rotierenden, Bürste schichtweise angeordnet. Typischerweise erfolgt das in Form eines Schichtstapels auf einer Arbeitsplattform in einem Arbeitsraum der Vorrichtung. Der Laser kann dabei zum sequentiellen lokalen An- oder Aufschmelzen von Pulverbestandteilen jeweils einer oder mehrerer Schichten des jeweils erzielten Pulver- oder Schlickerbetts dienen. Der Druckkopf dient dabei typischerweise zum Aufbringen eines Binders oder eines zweiten Baumaterials auf der jeweils obersten Baumaterialschicht des Schichtstapels, bevor die nächste Schicht aufgetragen und gemäß der für diese Schicht geltenden Konturen bearbeitet bzw. strukturiert wird. Auf diese Art und Weise wird schichtweise das Bauelement oder ein Rohling desselben ausgebildet.

Vorteilhaft ermöglicht das beschriebene Verfahren die material-, zeit- und kostensparende Herstellung einer Wand oder sogar eines Gebäuderohbaus, zumindest aber einer Wand oder eines Abschnitts einer oder mehrerer Wände. Ein besonderer Vorteil ergibt sich für das Design des betreffenden Gebäudes, da die Wand als Freiformfläche ausgebildet werden kann, d.h. in ihrer äußeren Kontur komplex geschwungen sein kann. Unter einer Freiformfläche wird in diesem Zusammenhang eine von einer planen Fläche abweichende, beispielsweise Rundungen und/oder Wölbungen aufweisende geschlossene oder mit Tür- und/oder Fensteröffnungen und/oder Nischen versehene Wandfläche verstanden.

Vorteilhaft geben die verfahrensgemäß gefertigten Bauelemente und letztlich die damit gebauten Wände dem Bauingenieur, dem Architekten bzw. dem Bauherren größtmögliche Gestaltungsfreiheit. Beispielsweise können Baukörper errichtet werden, die von der lebenden Natur inspiriert sind (biomimetisch sind) und/oder Prinzipien der Bionik nutzen.

Die funktionsgerechte Anordnung bzw. der funktionsgerechte Verlauf von Installationskanälen und/oder Ausnehmungen für Versorgungs- und Signalleitungen in den Bauelementen bzw. der Wand ermöglicht die bestimmungsgemäße Anordnung elektrischer Kabel (Kabelkanäle) und/oder der bestimmungsgemäßen Führung von Fluiden und/oder der bestimmungsgemäßen Anordnung entsprechender Schläuche und/oder Rohrleitungen (Rohren) im Gebäude, ohne dass dafür zuvor aufgestelltes Material wieder entfernt werden muss. Vorteilhaft kann mit Hilfe des offenbarten Verfahrens also die Anordnung bzw. der Verlauf benötigter Installationskanäle im Verband der vorgeschlagenen Systembausteine, in einer Wand umfassend einen Mauersteinverband, oder im gesamten Bauwerk bereits während der Projektierung des Bauwerks vorbestimmt werden, ohne das in Form des Rohbaus aufgestellte Material unter Belastung durch Staub, Schutt und Lärm zeitaufwendig entfernen zu müssen.

(2) Gemäß einer Ausführungsform erfolgt bei dem vorgeschlagene Verfahren das computergestützte Zerlegen der konstruierten Wand in zunächst virtuelle Bauelemente schichtweise. Der konstruierte Baukörper, im einfachsten Fall also die konstruierte Wand, wird in einzelne virtuelle Schichten zerlegt. Diese virtuellen Schichten sind zueinander benachbart und verlaufen im Wesentlichen horizontal. Der Verfahrensschritt computergestütztes Zerlegen erfolgt vergleichbar zu einem bei der additiven Fertigung fachüblich als Slicing bezeichneten Vorgehen. Beim Zerlegen werden die erhaltenen virtuellen Schichten also ihrerseits in eine Abfolge virtueller Bauelemente umfassend die oben genannte Vielzahl benachbarter Bauelemente aufgeteilt.

Die so erhaltenen - zunächst noch virtuellen Bauelemente - ähneln von ihrer äußeren Form her im Wesentlichen herkömmlichen Mauersteinen. Mit anderen Worten ausgedrückt, beschreiben die entsprechenden Steuerdatensätze zumindest zwei einander parallel gegenüberliegende Flächen, eine unterseitige Grund- oder Stellfläche und eine oberseitige Deckfläche, des virtuellen Bauelements und die im Inneren des durch diese Flächen begrenzten Raumes angeordneten Abschnitte des Installationskanals.

Vorteilhaft weisen die im Ergebnis des Prozessschritts additives Fertigen körperlich erhaltenen realen Bauelemente eine - von außen betrachtet - im Wesentlichen quaderförmige Form auf. Allgemeiner ausgedrückt, d.h. insbesondere abgesehen von etwaigen Hohlräumen bzw. den Installationskanalabschnitten oder Durchführungen weisen die Bauelemente die Form von Extrusionskörpern im geometrischen Sinne bzw. allgemein im mathematischen Sinn die Form von Zylindern auf.. Sie können, ähnlich Mauersteinen, angeordnet, bzw. "gemauert" werden, sodass letztlich die Wand ausbildbar ist, zumindest aber diejenigen Abschnitte der Wand, die den Installationskanal beinhalten. Hierbei versteht es sich von selbst, dass die verfahrensgemäß gefertigten Bauelemente mit dem vorgeschlagenen Verfahren so anpassbar sind, dass sie gemeinsam mit herkömmlich gefertigten Bauelementen, z.B. Hohlblocksteinen oder einem Fenstersturz oder einen herkömmlich gefertigten Türsturz, verbaut werden können. Ein Sturz weist aus Gründen der Statik typischerweise keinen Installationskanal auf. Gemäß Ausführungsformen sind aber ebenso Fenster- und Türstürze mit dem beschriebenen Verfahren herstellbar, können vorteilhaft sogar mit entsprechenden zusätzlichen, integrierten Versteifungselementen oder effektiv versteifenden internen Strukturen ausgerüstet werden.

(3) Gemäß einer Ausführungsform erfolgt das vorstehend beschriebene Aufteilen der zueinander benachbarten virtuellen Schichten in virtuelle Bauelemente so, dass im Wesentlichen vertikal angeordnete Flächen der Bauelemente unmittelbar zueinander benachbarter Schichten, die eine Wandfläche ausbilden, versetzt zueinander verlaufen.

Vorteilhaft ist mit den im Prozessschritt additives Fertigen gefertigten Bauelementen ein Verband in Form eines Mauersteinverbands ausbildbar. Ein solcher Mauersteinverband kann beispielsweise eine Läuferschicht umfassen, indem die Bauelemente einer Schicht so anordenbar sind, dass eine breite Seite der Bauelemente eine Wandfläche ausbildet. Der erzielbare Mauersteinverband der Bauelemente kann auch eine Binderschicht umfassen oder mit dieser vergleichbar sein, wenn die Bauelemente so orientiert sind, dass Kopfseiten der Bauelemente, also deren schmalere Seiten, eine Wandfläche bilden. Ebenso kann der gewissermaßen zunächst nur virtuell erzielte Bauelementeverband eine Rollschicht, d.h. eine spezielle Form der Binderschicht aufweisen. Im Vergleich zu letzterer sind die Bauelemente ("Steinen" vergleichbar) dabei um 90 Grad gedreht. Schließlich kann die ausbildbare Wandfläche eine sogenannte Grenadierschicht aufweisen, in der "Steine", also im Wesentlichen quaderförmige Bauelemente, gewissermaßen stehend nebeneinander gereiht angeordnet sind, sodass breite Seiten der Bauelemente die Wandfläche ausbilden. Vorteile der hier benannten Art des ausbildbaren Verbandes bzw. der Art des computergestützten Zerlegens einer Schicht der konstruierten Wand in die erwähnte Läuferschicht, Binderschicht, Rollschicht und/oder Grenadierschicht ergeben sich einerseits mit dekorativen Aspekten, vorrangig aber mit strukturell-stabilisierenden Effekten für die letztlich aus den verfahrensgemäß körperlich gefertigten Bauelementen errichtete Wand. Selbstredend erlaubt die eingangs erwähnte Formenvielfalt der typischerweise auf quaderförmige Grundelemente rückführbaren Bauelemente zahlreiche andersartige Anordnungen der Bauelemente in einer Wand, als mit Mauersteinen in einem Gemäuer. Insbesondere können verschränkte und verzahnte, nicht also nur schichtweise "gestapelte" Anordnungen der Bauelemente in der letztlich erzielten Wand vorgesehen sein.

(4) Gemäß einer Ausführungsform sind die Prozessschritte "Erstellen des Steuerdatensatzes" und "additives Fertigen" so angepasst, dass der Steuerdatensatz die Vorrichtung zur additiven Fertigung so steuert, dass der Abschnitt des Installationskanals mit zumindest zwei Öffnungen versehen ist, wobei eine Ebene einer ersten Querschnittsendfläche des Installationskanalabschnitts im Wesentlichen parallel oder im Wesentlichen orthogonal zu einer Ebene einer zweiten Querschnittsendfläche des Installationskanalabschnitts des gefertigten Bauelements orientiert ist.

Somit unterscheidet sich das gemäß dieser Ausführungsform gefertigte Bauelement von herkömmlichen Bausteinen, beispielsweise von Hohlsteinen oder Hohlblocksteinen, die typischerweise einen, zwei oder mehrere gerade durchgängige "Kanäle" aufweisen. Typischerweise sind deren Kanäle im verbauten Zustand vertikal orientiert. Diese Kanäle dienen funktional beispielsweise einer verbesserten Schall- und Wärmeisolation. Sie bleiben in der Regel zumindest teilweise leer, luftgefüllt und werden nicht von Fluiden durchströmt. In aller Regel werden sie beim Verbau der Hohlblocksteine durch die verwendeten Mörtelschichten verschlossen. Sie können aber auch genutzt werden, um eine größere Stabilität der damit errichteten Wand zu erzielen. Dazu werden Bewehrungsstäbe, beispielsweise Torstahl (Rippenstahl) in Kanäle übereinander angeordneter Hohlblocksteine eingeführt und mit Beton vergossen. Auch sind Gebäudewände bekannt, deren Mauersteine zwecks verbesserter Stabilität, beispielsweise in erdbebengefährdeten Gegenden, zusätzlich fixiert werden, indem in Kanälen mehrerer übereinander angeordneter Bausteine lange Schrauben mit Muttern das Mauerwerk fixieren. Die hier beschriebenen Installationskanäle der Bauelemente haben typischerweise eine andere Funktion.

(5) Gemäß einer Ausführungsform weist das vorgeschlagene Herstellungsverfahren einer Wand den Prozessschritt "Ausbilden der Wand" auf. Das Ausbilden der Wand erfolgt durch ein geordnetes und also bestimmungsgemäßes Fügen der Vielzahl der zunächst nur virtuell zueinander benachbarten Bauelemente. Die benachbarten Bauelemente werden optional mit einem Adhäsiv, beispielsweise mit einem Kleber, einem Mörtel, oder einem Zement in einem oder zu einem Verband, z.B. in Form einer die Wand ausbildenden Anordnung fixiert. Im Fall der Verwendung konventioneller Mauersteine zum Aufbau einer Wand wird deren Verband üblicherweise als Mauerverband bezeichnet. Der Begriff "Bauelementverband" wird hier analog dazu verwendet.

Vorteilhaft sind die Bauelemente also nicht nur in Hinsicht auf die Ausbildung des im Inneren der Wand liegenden Installationskanals konfiguriert, sondern durch ihre jeweilige äußere Form eingerichtet, einen weitestgehend formschlüssigen oder annähernd formschlüssigen Verband auszubilden. Die Breite einer oder mehrerer Fugen zwischen benachbarten Bauelementen ist über den Verfahrensschritt "computergestütztes Erstellen eines Steuerdatensatzes..." je nach Wunsch und/oder Erfordernis, also abgestimmt auf das jeweilige Adhäsiv und etwaige geltende Bau-Normen und/oder -Vorschriften vorgebbar.

(6) Gemäß einer Ausführungsform ist der Installationskanal angepasst hinsichtlich seiner Maße: des Querschnitts, seiner Länge, seiner Breite und Tiefe, hinsichtlich seiner Position relativ zu einer Seitenfläche des Bauelements, hinsichtlich von Oberflächeneigenschaften wie: Struktur, Porosität, Benetzungseigenschaften, hinsichtlich der Materialart seiner Kanalwände etc. für eine Installation, z.B. die Aufnahme und/oder Führung eines Kabels, insbesondere eines Stromkabels, einer Signalleitung, eines Lichtleiters oder einer Lichtleitfaser, eines Rohres, beispielsweise eines flexiblen Schlauches und/oder für den Transport eines Fluids. Das im Kanal angeordnete und/oder transportierte oder transportierbare Fluid ist ausgewählt unter: einem Trinkwasser, einem Brauchwasser, einem Abwasser, einer Löschflüssigkeit, einem Löschschaum, einem Gas (z.B. einem Löschgas wie Argon zur Sauerstoffverdrängung in einem Serverraum) und einem Gasgemisch (z.B. Zu- oder Abluft, Klimatisierung, ggf. auch be- oder entfeuchteter Luft.

Vorteile ergeben sich aus der Vielfalt der jeweiligen Installation und erschlossenen Anwendungen. Eingangs wurde erwähnt, dass die technische Ausrüstung eines Gebäudes dieses erst nutzbar macht, beispielsweise bewohnbar macht.

(7) Gemäß einer Ausführungsform umfasst die Vielzahl der Bauelemente zumindest 3, bevorzugt 3 bis zu einer 1 Million, weiter bevorzugt 10 bis 50.000 Stück.

Dabei wird davon ausgegangen, dass der Rohbau eines Hauses typischerweise 100 Tonnen oder mehr wiegen kann. Vorteilhaft weisen die zur Errichtung des Rohbaus erforderlichen Bauelemente dann eine durchschnittliche Masse von etwa 5-10 kg auf. Bauelemente dieser Masse sind individuell gut und präzise handhabbar. Der Begriff Handhabbarkeit bezieht sich hierbei sowohl auf ein buchstäblich durch menschlicher Hände Arbeit errichtetes Bauwerk, als auch auf ein mit angepassten Maschinen, beispielsweise einem Roboter, einem Kran, einem Stapler oder einer Transport-Drohne montiertes Gebäude. Das Erfordernis einer präzisen Handhabbarkeit ergibt sich aus der Notwendigkeit einer exakten und passgenauen Anordnung der die Wand oder die Wände ausbildenden Bauelemente und der funktionell erforderlichen Integrität zugehöriger Installationskanäle. Bauelemente größerer Masse als etwa 10 kg erfordern allein auf Grund des Trägheitsmomentes bei deren Bewegung wesentlich robustere und aufwendigere Montageanlagen, die wiederum höhere Kosten verursachen. Das Heben schwererer Lasten, umso mehr deren präzises Platzieren ist körperlich beschwerlich und wird über längere Zeiträume unzumutbar oder gar unmöglich.

(8) Gemäß einer Ausführungsform weist das im Ergebnis des Verfahrens gefertigte Bauelement eine im Wesentlichen quaderförmige Form auf und/oder ist rückführbar auf quaderförmige Grundformen, wobei es typischerweise an einander gegenüberliegenden Seiten Verankerungsstrukturen aufweist, die durch ihre jeweilige Größe, Form und Position, mit anderen Worten durch ihre Lage und Passform, so hergerichtet sind, dass zumindest abschnittsweise ein Eingriff ausbildbar ist zwischen einer ersten Verankerungsstruktur eines ersten Bauelements und einer zweiten Verankerungsstruktur eines zweiten Bauelements das in der Wand neben, unter, hinter, vor oder über dem ersten Bauelement angeordnet ist.

Vorteilhaft sichert diese äußere Form der Bauelemente und deren Eingriff eine hohe Stabilität der errichteten Mauer, letztlich des die Wand aufweisenden Bauwerks.

(9) Gemäß einer Ausführungsform weist das vorgeschlagene Verfahren einen Prozessschritt individuelles Verpacken mit einem Verpackungsmaterial der gefertigten Bauelemente auf.

Das Verpacken kann beispielsweise mit einer Schrumpffolie erfolgen. Vorteilhaft, ist so jedes der gefertigten Bauelemente vor Schmutz, Wasser oder anderen klimatischen Einflüssen unmittelbar nach deren Herstellung, während ihrer Lagerung und ihrem Transport zur Baustelle geschützt. Zusätzlich ist das Verpackungsmaterial angepasst, einen zuverlässigen mechanischen Schutz zu gewährleisten. Entsprechende Materialien sind beispielsweise ausgewählt unter Folien umfassend ein geschäumtes Polymer, dicken Polymerfolien und sogenannten Luftpolsterfolien.

(10) Gemäß einer Ausführungsform erfolgt der Verfahrensschritt "computergestütztes Zerlegen der konstruierten Wand in die Bauelemente" so, dass die Materialdichte des zum Fertigen der Bauelemente verwendeten Baustoffs berücksichtigt wird. Für unterschiedliche Baustoffe können sich so unterschiedliche Maße und/oder Formen (Konturen) der letztlich erhaltenen Bauelemente ergeben. Ein technisches Ergebnis dieses Verfahrensschrittes ist, dass unter Berücksichtigung der Materialdichte des jeweils zur additiven Fertigung verwendeten Baustoffs eine Masse der Bauelemente zwischen 1 kg und 25 kg, bevorzugt zwischen 5 kg und 10 kg liegt.

Vorteilhaft sind diese Bauelemente mit einem vergleichsweise geringen Aufwand individuell und präzise handhabbar, vor allem aber auch präzise platzierbar. Die Form der Bauelemente wird im Wesentlichen durch ihre Funktion bestimmt. Beispielsweise ragen funktional als Türsturz oder als Fenstersturz zu verwendende Bauelemente an beiden Auflageseiten ("Auflagern") über der betreffenden Tür- oder Fensteröffnung ausreichend weit in die betreffende Wand hinein und weisen die erforderliche Belastbarkeit gegenüber einer anzunehmenden Dauerlast und möglicher Verkehrslasten auf. Grundsätzlich wird jedoch angemerkt, dass die Bauelemente bevorzugt weder hinsichtlich ihrer Maße (Größen) noch ihrer Masse (Gewicht) beschränkt sind, da sie ja auch mittels entsprechend ausgelegter Roboter montiert werden können. Zweckmäßigerweise sind alle Bauelemente ähnlich groß und schwer. Das ist jedoch auch nicht zwingend, erleichtert aber den Montageprozess für Mensch und/oder Roboter. Einige wenige der in einer Wand verwendeten Bauelemente können aus konstruktiven Gründen, z.B. um Fenster- und Türöffnungen zu überbrücken (Stürze) länger gestaltet sein, unter Umständen durch eingebrachte Armierungen oder anders verstärkt und durchaus auch nicht additiv gefertigt sein.

Vorteilhaft ermöglicht das eine hohe Flexibilität in der Konstruktion des Bauwerks.

(11) Gemäß einer Ausführungsform umfasst das vorgeschlagene Verfahren ein Markieren der Bauelemente mit einem ihre jeweilige Position in der Wand kennzeichnenden individuellen Code. Der Code kann eine Zahlenkombination sein, etwa eine fortlaufende Nummer der Schicht und eine fortlaufende Nummer, welche die Position des Bauelements in der betreffenden Schicht kennzeichnet. Ebenso oder zusätzlich ist aber auch ein Strichcode oder eine andersartige maschinenlesbare Markierung geeignet. Die Codes werden bevorzugt direkt während des additiven Fertigens des Bauelements erzeugt. Das kann beispielsweise durch lokales Ein- oder Aufbringen eines Pigments, eines unterscheidbar pigmentierten Baustoffs oder durch gezieltes Erzeugen außenseitiger Ausnehmungen oder Erhabenheiten erfolgen. Alternativ kann die Markierung in Form eines Etiketts auf dem Bauelement oder auf der Verpackung desselben aufgebracht oder angebracht werden. Ebenso ist zunächst temporär eine ausschließliche Markierung derjenigen Arbeitsplattform, auf der das konkrete Bauelement gefertigt wird möglich. Diese Markierung oder eine Entsprechung derselben, eines Codes oder ein Äquivalent dieses Codes kann zu einem späteren Zeitpunkt auf das Bauelement übertragen werden. Das kann direkt erfolgen, aber auch indirekt, beispielsweise durch ein Markieren der Verpackung des individuellen Bauelements.

Vorteilhaft erleichtert das die Montage der Bauelemente, den eigentlichen Bau vor Ort. Fehler, Instabilitäten durch falsch platzierte Bauelemente und/oder ungewollte Unterbrechungen eines Installationskanals werden so weitestgehend vermieden oder, bei einer zusätzlichen "Kodierung" beispielsweise nach den Prinzipien eines 3D-Puzzles (d.h. dem Vorhandensein eineindeutiger Passungen von korrekt platzierten zueinander benachbarten Bauelementen, völlig ausgeschlossen.

(12) Gemäß einer Ausführungsform wird im Prozessschritt "additives Fertigen des Bauelements..." ein Baustoff verwendet, umfassend: einen Beton, einen Mörtel, einen Lehm, einen Ton, ein Alumosilikat, eine kieselsäurehaltige Verbindung, ein Metakaolin, ein organisches Polymer, ein vernetzungsfähiges Monomer, ein Puzzolan und/oder ein zu einer Geopolymerbildung geeignetes Materialgemisch. Die entsprechenden Materialien können optional faserverstärkt sein. So kann beispielsweise ein mit Strohhäcksel oder anderen Pflanzenfasern oder Resten vermengter Lehm oder Ton verwendet werden. Auch kann ein mit geschreddertem glasfaserverstärktem Kunststoff (GFK) versetzter Beton genutzt werden. Unter einem vernetzungsfähigen Polymer werden organische Verbindungen verstanden, die typischerweise zumindest 2 funktionelle Gruppen aufweisen bzw. eine organische Verbindung, die konfiguriert ist, eine Vernetzungsreaktion mit artgleichen, artverwandten oder anderen organischen makromolekularen Verbindungen zu ermöglichen.

Vorteilhaft gewährleisten die verwendeten Materialien und Zuschlagstoffe eine projektierte Festigkeit und/oder ein gewünschtes Raumklima, reduzieren Baukosten und sind unter Umständen als Abfall (z.B. geschreddertes Material außer Betrieb gestellter Flügel von Windkraftanlagen) sogar zu negativen Kosten erhältlich.

(13) Gemäß einer Ausführungsform wird im Prozessschritt "additives Fertigen..." in den Bauelementen ein Gradient einer relativen Konzentration einer Baustoffart, einer Baustoffdichte, einer Porosität, einer Pigmentierung, einer Benetzbarkeit, einer Wärmeleitfähigkeit, und/oder einer Schalldämmwirkung erzeugt, wobei der Gradient im Wesentlichen orthogonal zu einer Wandfläche orientiert ist.

Vorteilhaft gewährleistet oder zumindest befördert das ein gewünschtes Raumklima. Die Wärmeleitfähigkeit λ hat Bedeutung für die Lage des Taupunktes bzw. einer Taupunktebene im Bauwerk, sodass beispielsweise durch Unterbinden einer Kondensation eine Schimmelbildung in Wohnräumen unterdrückt werden kann. Weitere Vorteile umfassen beispielsweise verringerte Material- oder Heizkosten oder sind für den Fachmann offensichtlich.

(14) Gemäß einer Ausführungsform weist das vorgeschlagene Verfahren die folgenden zusätzlichen Prozessschritte auf:
- automatisches Aufnehmen und Anordnen der Vielzahl Bauelemente auf einem Transportmittel;
- Transportieren der auf dem Transportmittel angeordneten Vielzahl Bauelemente zu einer Baustelle;
- Entladen des Transportmittels umfassend ein geordnetes Absetzen und/oder Anordnen der Vielzahl Bauelemente auf einer Lagerfläche, wobei das geordnete Absetzen entsprechend der durch den jeweiligen Code vorgegebenen Position der Bauelemente in der Wand bestimmt ist und/oder einer Reihenfolge des oben genannten fortlaufenden Codes entspricht, und/oder
- bestimmungsgemäßes Anordnen der Vielzahl Bauelemente direkt auf einer angepassten Gründung, beispielsweise auf einem Fundament oder einem als untere Etage ausgebildeten Baustruktur, wobei das bestimmungsgemäße Anordnen unter Verwendung einer individuellen Markierung bzw. eines individuellen Codes der Bauelemente erfolgt und benachbart zueinander angeordnete Bauelemente optional durch ein Adhäsiv fixiert werden.

Dabei kann das Transportmittel ausgewählt sein unter einem Schienenfahrzeug, einem Lastkraftwagen (LKW), einem Luftfahrzeug, insbesondere einer Drohne: das bestimmungsgemäße Anordnen erfolgt unter Verwendung einer bereits zuvor beschriebenen individuellen Markierung der Bauelemente. Optional werden benachbarte Bauelemente bei ihrer bestimmungsgemäßen Anordnung durch eines oder mehrere der bereits beschriebenen Adhäsive fixiert.

Vorteilhaft tragen diese Prozessschritte zu einer übersichtlichen und platzsparenden Baustelle bei und verringern so die anfallenden Baukosten. Der eigentliche Bauprozess des die Wand aufweisenden Bauwerks ist hierbei mit "dem bestimmungsgemäßen Anordnen der Bauelemente auf einer Gründung" beschrieben. Dieser Prozessschritt macht eine Zwischenlagerung der Bauelemente überflüssig, kann aber auch einer solchen nachfolgen. An Stelle des Entladens auf eine Lagerfläche erfolgt mithin sofort der Aufbau der Wand oder eines Gebäudes vom Transportmittel aus. Das spart zusätzlich Platz, Zeit und damit Baukosten. Das Transportmittel ist, beispielsweise mit einem daran befestigten oder gesonderten, mit diesem assoziiertes Hebezeug bzw. Hebevorrichtung ausgestattet, beispielsweise einem Kran. Dabei wird unter einer assoziierten Hebevorrichtung / Hebezeug eine dem Transportmittel zugeordnete und mit diesem direkt oder seinem zugeordneten Bediener kommunizierende bzw. steuerbare Vorrichtung, z.B. ein Kran oder ein Roboterarm mit Greifer verstanden. Ebenso kann das Transportmittel eine Drohne umfassen, die am Haltepunkt des Transportmittels in Betrieb gesetzt wird und die Bauelemente individuell vom Transportmittel oder von der Lagerfläche aufnimmt und bestimmungsgemäß auf der Gründung bzw. auf bereits verbauten Bauelementen anordnet. Dazu kann das Auftragens einer Adhäsivschicht ebenso durch die entsprechend konfigurierte Drohne erfolgen. Diese kann zu diesem Zweck einen Adhäsivvorratsbehälter und eine Dosiervorrichtung für das Adhäsiv aufweisen. Selbstredend kann das Aufbauen alternativ auch manuell oder teilweise manuell erfolgen.

(15) Gemäß einer Ausführungsform wird ein Bauelement vorgeschlagen, das konfiguriert ist zum Aufbau einer Wand. Das Bauelement hat eine untere Stellfläche, eine der unteren Stellfläche typischerweise parallel gegenüberliegende obere Anschlussfläche, sowie zumindest eine Seitenfläche. Beispielsweise kann das Bauelement eine nahezu elliptische Grundfläche oder eine einseitig konvexe und eine gegenüberliegende einseitig konkave Anschlussfläche haben. Streng genommen weist ein solches Bauelement nur eine umlaufende Seitenfläche auf, da keine Kanten die Seitenfläche in mehrere Seitenflächen unterteilen. Mit anderen Worten ausgedrückt verbindet die zumindest eine Seitenfläche eine äußere Kontur x₁₀, y₁₀ der unteren Stellfläche mit einer äußeren Kontur der oberen Anschlussfläche x₁₁, y₁₁ in einer im Wesentlichen vertikalen Richtung z miteinander (extrusionskörperförmig), wobei zumindest zwei oder sogar drei in der Wand benachbarte Bauelemente im Ergebnis ihres bestimmungsgemäßen Anordnens, Zusammenfügens bzw. Montierens zumindest einen Abschnitt eines im Inneren der Wand angeordneten Installationskanals und/oder einen Abschnitt einer Öffnung, ausgewählt unter einer Fensteröffnung und einer Türöffnung ausbilden und wobei das Bauelement optional eine Markierung aufweist, in der bzw. mittels der die Position des Bauelements in der Wand kodiert ist.

Vorteilhaft sind derartige Bauelemente zur effizienten Errichtung einer Wand geeignet, die verschiedene technische Versorgungsleitungen bzw. Installationskanäle zu deren Aufnahme aufweist. Wie nachfolgend noch detaillierter erläutert, ermöglichen es die beschriebene Bauelemente, einen Rohbau eines so komplexen Bauwerks, wie beispielsweise eines Einfamilienhauses, bereitzustellen, der zum Zeitpunkt seiner Fertigstellung bereits weitestgehend alle versorgungstechnischen Installationen aufweist oder unmittelbar zu deren Installation vorbereitet ist.

(16) Gemäß einer Ausführungsform weist der Abschnitt des Installationskanals des Bauelements zumindest zwei Öffnungen auf und eine Ebene der ersten Querschnittsendfläche des Installationskanalabschnitts ist im Wesentlichen parallel oder im Wesentlichen orthogonal zu einer Ebene der zweiten Querschnittsendfläche des im Bauelement angeordneten Abschnitt des Installationskanals orientiert.

Hieraus ergibt sich, dass der Installationskanalabschnitt eines Bauelements auch T-förmig sein kann. Der vorstehend als orthogonal benannte Winkel von 90° kann ebenso durch einen Winkel von 120° ersetzt werden. Der resultierende Installationskanalabschnitt folgt dann nicht mehr buchstäblich einer L-Form. Im Falle von drei Querschnittsendflächen ergibt sich dann eine Y-Form. Vorteile von L-, T- und Y- förmigen Rohrstutzen sind allgemein bekannt und gelten hier ebenso. Vorteilhaft wird beispielsweise mit dem L-förmigen Installationskanalabschnitt des Bauelements ein im Wesentlichen rechtwinkliger Verlauf, bzw. ein Richtungswechsel des betreffenden Installationskanals erzielt. Entsprechende Installationskanäle bzw. -abschnitte können zur Erzeugung eines mäanderförmigen Verlaufs des Installationskanals in der Wand beitragen, wenn sie mit weiteren Bauelementen geeignet kombiniert werden, deren Installationskanalabschnitte horizontal oder vertikal orientiert sind. Selbstredend sind die entsprechenden zwei oder drei Öffnungen benachbarter Bauelemente so im jeweiligen Bauelement angeordnet, dass bei deren Verbau in der Wand ein geschlossener, und von Stufen oder Sprüngen freier Installationskanal erzielt wird. Mäandernde Kanäle können Vorteile für ein den Kanal durchströmendes Fluid bieten, beispielsweise für die Klimatisierung / Heizung oder Kühlung eines Raumes mit einem Fluid (Gas oder Flüssigkeit).

(17) Gemäß einer Ausführungsform ist das vorgeschlagene Bauelement im Wesentlichen quaderförmig. Unter "im Wesentlichen quaderförmig" wird ein im Wesentlichen rechtwinkliges dreidimensionales Parallelepiped verstanden. Dieses weist 6 im Wesentlichen rechteckige Seitenflächen auf, die in im Wesentlichen rechten Winkeln aufeinander stehen. Zumindest ein Teil der 12 Kanten der im Wesentlichen rechteckigen Seitenflächen können gefast bzw. abgerundet sein, sodass resultierende 8 Ecken auch eine abgerundete Form haben. Unter "im Wesentlichen" werden dabei Abweichungen von den benannten Werten, hier konkret von rechten Winkeln, um bis zu ± 5 ° verstanden. Weiter ist das Bauelement angepasst, eine Wand flächenfüllend auszubilden. Hierbei wird unter dem Begriff "flächenfüllend" eine derartige Gestaltung einer an der Ausbildung einer Außenfläche der Wand beteiligten Seitenfläche des Bauelements verstanden, die angepasst ist zur Ausbildung einer durchgehend geschlossenen Wandfläche, die also im Verband der Bauelemente bzw. in verbautem Zustand zu einer geschlossenen Sichtfläche der Wand führt. Das Bauelement dieser Ausführungsform weist an einander gegenüberliegenden Seiten Verankerungsstrukturen auf, die durch ihre jeweilige Größe, Form und Position, d.h. Lage und Passform individuell abhängig von ihrer Position an den Bauelementen in der Wand so konfiguriert sind, dass zumindest abschnittsweise ein Eingriff von Verankerungsstrukturen benachbarter Bauelemente ausbildbar ist. Somit werden durch die Verankerungsstrukturen eines Bauelements zumindest ein Eingriff einer ersten Verankerungsstruktur des ersten Bauelements mit einer zweiten Verankerungsstruktur eines in der Wand benachbarten zweiten Bauelements und ein Eingriff einer zweiten Verankerungsstruktur des ersten Bauelements mit einer Verankerungsstruktur eines in der Wand zum ersten Bauelement benachbarten dritten Bauelements realisiert. Das erste Bauelement wird zumindest von zwei weiteren Bauelementen umgeben, in einem Bauelementeverband einer Wand idealerweise sogar von sechs anderen Bauelementen umgeben. Die Seitenfläche des Bauelements nach dieser Ausführungsform ist mithin konfiguriert, mit zumindest zwei benachbarten Bauelementen zumindest abschnittsweise eine formschlüssige oder eine durch eine Adhäsivzwischenschicht vermittelte, nahezu formschlüssige Verbindung (Verzahnung, Eingriff) auszubilden bzw. einzugehen. Zusätzlich kann vermittels eines schrittweisen Versatzes der jeweiligen Verankerungselemente oder eine variierende Form und/oder Größe der in einer Schicht und/oder in benachbarten Schichten angeordneten Bauelemente und/oder darauf angeordneten Noppen und Ausnehmungen eine falsche Anordnung der Bauelemente, zusätzlich zu deren individueller Codierung, verhindert werden. Unter falscher Anordnung ist hier eine von der projektierten (d.h. konstruierten) Anordnung der Bauelemente in der Wand abweichende und beispielsweise zu einem unbeabsichtigten Unterbrechen oder einem Verschluss des Installationskanals führende Montage zu verstehen.

(18) Gemäß einer Ausführungsform weicht eine Orientierung des Installationskanals in einem Bauelement der Vielzahl der verfahrensgemäß hergestellten Bauelemente zumindest abschnittsweise von einer zur unteren Stellfläche orthogonalen Orientierung ab.

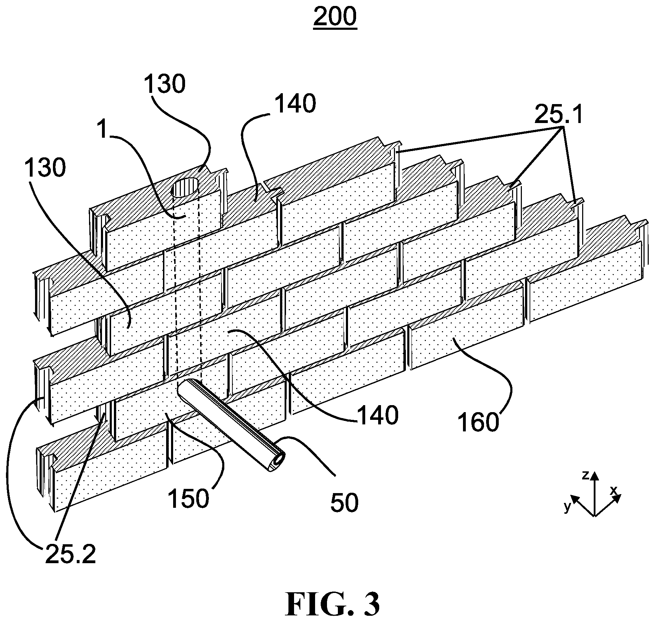

Optional beträgt die Abweichung eines Teils des Kanalabschnitts, projiziert in eine Ebene, in der eine Seitenfläche des Bauelements liegt, bzw. in der Wandebene, beispielsweise im Wesentlichen 90°. Ebenso sind Abweichungen um im Wesentlichen 45° möglich. Vorteilhaft ermöglicht das die Verwirklichung eines komplexen Verlauf des Installationskanals in der Wand ohne von dem gemäß ggf. geltenden Bauvorschriften vorgeschriebenen waage- oder senkrechten Verlauf von Versorgungsleitungen abzuweichen. Ebenso ermöglicht das bei abschnittsweise orthogonaler Orientierung zur Wandfläche die standardmäßige Ankopplung an eine externe Versorgungsleitung (vgl. Fig. 3), einen Ein- oder einen Auslass.

(19) Gemäß einer Ausführungsform weist das Bauelement eine erste Öffnung des Installationskanals an einer Seitenfläche des Bauelements auf. Eine zweite Öffnung des Installationskanalabschnitts des Bauelements kann an der unteren Stellfläche oder an der oberen Anschlussfläche angeordnet sein. Gemäß einer Modifikation dieser Ausführungsform ist eine Installationskanalöffnung unmittelbar in einer Verankerungsstruktur angeordnet. Mit dem Ausbilden eines Eingriffs der korrespondierenden Verankerungsstrukturen der in der Wand benachbarten Bauelemente bei deren Montage, wird so ein weitestgehend fluiddichter Installationskanal erzielt. Das vorstehend bereits erläuterte Imprägnieren von Installationskanalabschnitten mit einem Imprägniermittel kann vorteilhaft auch erst nach vollständiger Montage aller entsprechenden Bauelemente der Wand oder des Gebäudes erfolgen.

Vorteilhaft kann so beispielsweise eine Rohrleitung quasi "gelegt" werden, ohne den üblicherweise erforderlichen Installationsaufwand, die üblicherweise nachträglich in den Rohbau eingebrachten Mauerdurchbrüche etc., da die Rohrleitung zeitgleich mit der Wand, bzw. dem Rohbau ausgebildet wird.

(20) Vorteilhaft folgt der Installationskanal gemäß einer Ausführungsform in einem konstanten Abstand einer inneren oder einer äußeren Seitenfläche des Bauelements und verläuft damit entlang einer Isotherme, wenn zwischen innerer und äußerer Fläche der Bauelemente, bezogen auf die äußere Umgebung, ein Temperaturunterschied herrscht. Derartige Temperaturunterschiede zwischen einer äußeren Fläche, z.B. einer Hausaussenseite, und einer inneren Wandfläche, einer Hausinnenseite, treten typischerweise bei wechselnden klimatischen äußeren Bedingungen und/oder beim Beheizen eines Hauses auf. Die Bedeutung der Lage der Taupunktebene und die Gefahr einer Kondensation an Innenwänden ist dem Fachmann vertraut, sodass auch die Vorteile einer korrekten Anordnung eines entsprechenden Installationskanals bzw. der Temperatur des darin geführten Fluids offensichtlich sind.

Die vorgeschlagenen Installationskanäle müssen nicht zwingend eine zu installierende Infrastruktur, also Kabel, gesondert zu verlegende Rohre führen, sondern können auch Funktionalitäten erfüllen, wie eine Durchlüftung zusammen mit einer Kühlung oder Heizung oder zur Feuchtigkeitsregulierung des Bauwerks, z.B. eines Hauses, in den betreffenden Bauelementen einer Wand eingefügt sein, damit also in der Wand angeordnet sein.

(21) Gemäß weiteren Ausführungsformen kann ein Querschnitt bzw. die Querschnittsfläche eines Installationskanales eine bevorzugte geometrische Form aufweisen: beispielsweise kreisförmig, ellipsenförmig, quadratisch, rechteckig, sternförmig etc. sein. Die Querschnittsfläche kann mithin beschreibbar sein als: Kreis, Ellipse, Dreieck, Rechteck, Quadrat, Trapez, Trapezoid, Stern und Polygon, Typisch sind dabei mittlere Durchmesser von 0,5 bis 500 mm. Selbstredend sind die Installationskanäle in ihrer Dimensionierung auf eine Stärke der Wand, bzw. eine Tiefe der betreffenden Bauelemente abgestimmt.

Vorteilhaft kann beispielsweise ein sternförmiger Querschnitt des Installationskanals eine vergrößerte Kontaktfläche eines im Installationskanal strömenden Fluids zum Baustoff, bzw. dem Bauelement und damit der Wand gewährleisten. Das ermöglicht eine verbesserte Wärmeübertragung bzw. Temperierung bei der Verwendung des Installationskanals zur Klimatisierung.

(22) Gemäß einer Ausführungsform ist der Installationskanalabschnitt im Bauelement als freitragende Struktur ausgebildet. Mit anderen Worten ausgedrückt, kann der Installationskanalabschnitt in einer vollmassiven Baustoffmatrix eingebettet erscheinen, kann alternativ aber auch nur abschnittsweise zu seiner Stabilisierung mit einem als Installationskanalwandung erscheinenden Anteil des Baustoffs zu einer oder zu beiden der einander im Wesentlichen parallel gegenüberliegenden Außenseiten des Bauelements verbunden sein. Mit anderen Worten ausgedrückt ist die Wandung des Installationskanals zumindest abschnittsweise von einem oder mehreren Hohlräumen umgeben. Letztgenannte Anordnung wird hier als freitragende Anordnung des Installationskanals bezeichnet.

Vorteile einer freitragenden Anordnung des Installationskanalabschnitts im Bauelement bzw. des Installationskanals in der aus den Bauelementen aufgebauten Wand umfassen einerseits Aspekte einer Wärmedämmung und Isolation: Die in freibleibenden Hohlräumen vorliegende Luft wirkt als effektive Wärmedämmung, verbessert das Raumklima und bewirkt eine Energieersparnis beim Beheizen oder Kühlen des unter Beteiligung der Wand ausgebildeten Raumes.

Andererseits ermöglicht eine geeignete "Aufhängung", also die freitragende Anordnung des Installationskanalabschnitts im betreffenden Bauelement, bzw. in der aus derartigen Bauelementen aufgebauten Wand, dass ein für pulverbasierte Fertigungsverfahren allein schon aus ökonomischen Gründen sinnvolles "depowdering", also ein Entfernen nicht verfestigter Anteile des Pulverbettes, zumindest teilweise erfolgen kann. Zur Stabilisierung des Installationskanalabschnitts im Bauelement, bzw. des Installationskanals in der Wand kann eine Vielzahl einzelner, beispielsweise stabförmiger, Verbindungen zu den Außenseiten des Bauelements / der Wand dienen. Deren Verwendung oder die Verwendung einer GyroidStruktur als Verbindung des Installationskanalabschnitts mit Abschnitten der äußeren Seitenflächen des Bauelements erlaubt vorteilhaft ein vollständiges Depowdering, also vollständiges Entfernen des im Pulverbett ursprünglich eingesetzten Pulvers. Die bei diesem Freistellungsschritt entfernten Anteile des typischerweise nach wie vor rieselfähigen Pulvers oder Granulats können dem additiven Fertigungsprozess, z.B. zur additiven Fertigung des nächsten Bauelements, erneut zugeführt werden. Das so erfolgende "Recycling" eines pulverförmigen Baustoffs verbessert oder ermöglich überhaupt die höchstmögliche Nachhaltigkeit des hier verwendeten additiven Fertigungsverfahrens.

(23) Gemäß einer Ausführungsform mündet der Installationskanalabschnitt des Bauelements in eine Installationskanalöffnung in einer Seitenfläche des Bauelements und schließt bündig mit der Wandfläche ab. Diese Öffnung kann sowohl einen anderen Innendurchmesser und auch eine anders geformte Querschnittsfläche aufweisen, als der oder die zu ihr hinführenden Installationskanalabschnitte des einzelnen oder mehrerer einzelner Bauelemente. Mit anderen Worten ausgedrückt, können in diese Installationskanalöffnung mehrere Installationskanalabschnitte unterschiedlicher Bauelemente einmünden. Die Öffnung kann als eine von außen zugängliche Verteilerbox für elektrische Anschlüsse dienen. Sie kann vorteilhaft mittels eines Deckels, vorzugsweise aus Kunststoff, abgedeckt werden und bleibt somit zugänglich. Die Verteilerbox fungiert beispielsweise als Schnittstelle einer Vielzahl von Kanälen, durch die elektrische Leitungen geführt werden. Mithin ist zumindest ein Installationskanal über die Öffnung bzw. über die Verteilerbox zugänglich. Der Querschnitt der Öffnung kann vorzugsweise rund, quadratisch oder rechteckig geformt sein. Sie bietet genügend Platz, so dass Kabel mit Klammern verbunden sein können. Ebenfalls können vorzugsweise runde Boxen, als Aufnahme für Steckdosen oder für Schalter in Verbindung mit entsprechenden Leitungskanälen bzw. Versorgungsleitungen dienen.

Vorteilhaft erleichtert das die Installation kompletter Versorgungsstrukturen eines Raumes bzw. eines Gebäudes.

(24) Gemäß einer Ausführungsform wird ein Bausatz bzw. Kit zum Aufbau einer Wand vorgeschlagen, wobei die Wand einen Installationskanal und/oder optional eine Öffnung ausgewählt unter einer Türöffnung und einer Fensteröffnung aufweist. Der Bausatz umfasst eine Vielzahl Bauelemente gemäß der vorstehend und nachfolgend beschriebenen Ausführungsformen. Diese Bauelemente des Bausatzes sind so konfiguriert, dass sie bei einer projektgemäßen bzw. mit dem oben beschriebenen Verfahren projektierten sequentiellen Anordnung die Wand ausbilden, wobei eine Vielzahl der Bauelemente des Bausatzes zumindest jeweils einen Abschnitt des Installationskanals und/oder optional einen Abschnitt der bezeichneten Öffnung ausbilden.

Die erreichbaren Vorteile sind die vorstehend bereits benannten.

(25) Gemäß einer Ausführungsform wird ein **Gebäuderohbau,** umfassend zumindest eine Wand vorgeschlagen, wobei die Wand aus einer Vielzahl Bauelemente aufgebaut ist. Diese Bauelemente sind hergestellt gemäß zumindest einer der oben genannten Ausführungsformen. Mit anderen Worten ausgedrückt umfasst der Gebäuderohbau zumindest eine Wand, aufweisend Bauelemente gemäß zumindest einer der oben beschriebenen entsprechenden Ausführungsformen von Bauelementen. Nochmals mit anderen Worten ausgedrückt, kann der Gebäuderohbau Bauelemente gemäß dem vorstehend beschriebenen Bausatz umfassen. Dabei bleibt hier bewusst offen, wie das Dach des Gebäuderohbaus aufgebaut ist. Es kann mit einem traditionellen Dach mit Dachstuhl ausgestattet sein. Mehrere Wände können computergestützt aber auch so konstruiert werden, dass die verfahrensgemäß additiv gefertigten Bauelemente bei ihrem bestimmungsgemäßen Anordnen ein Gewölbe oder eine Kuppel bilden. Beispiele hierfür sind ein Kreuzgewölbe, ein Klostergewölbe, ein Spitzgewölbe, ein Tonnengewölbe, ein Spiegelgewölbe, eine Kuppel, eine Hängekuppel oder jedwede andere selbsttragende Struktur, die das Gebäude nach oben abschließt. Der Gebäuderohbau umfassend die Bauelemente kann jeweilige für die Stabilität des Bauwerks erforderliche Stützelemente, Verstärkungen oder Verstrebungen aufweisen, die ihrerseits aus den hier vorgeschlagenen additiv individuell gefertigten Bauelementen bestehen oder neben anderen Werksteinen solche aufweisen.

Vorteilhaft gewährleistet das größtmögliche Designfreiheit, Formenvielfalt und Stabilität.

Die vorstehend beschriebenen Ausführungsformen können beliebig miteinander kombiniert werden.

Zu den insgesamt mit einzelnen der beschriebenen Ausführungsformen oder deren Kombinationen erreichbaren Vorteilen zählen zusätzlich zu den bereits benannten weiterhin der mögliche Verzicht auf eine Verschalung beim Errichten des Gebäudes. Weiterhin wird mit der vorgeschlagenen Prozesskette die Nutzung von Baustoffen erschlossen, deren Verwendung sonst durch einzuhaltende Wartezeiten bis zum Erreichen der Endfestigkeit durch ein notwendiges Aushärten ("Reifen"), oder ein vollständiges Erstarren nicht für eine kontinuierliche additive Fertigung in Betracht kommen. Dadurch, dass die einzelnen individuellen Bauelemente auch individuell additiv gefertigt werden, können besonders nachhaltige Baustoffe, wie Lehm, Lehm-Faser-Gemische und/oder beispielsweise Pasten aus diversen inerten Abfallstoffen und deren Mischungen für die Herstellung von weit komplexeren Bausteinen, als einfachen Formsteinen für das Bauwesen erschlossen werden, da unabhängig von den jeweils für ein einzelnes Bauelement einzuhaltenden Wartezeiten der Fertigungsprozess weiterer Bauelemente angeschlossen werden kann. Die verwendete Vorrichtung zur additiven Fertigung kann also ohne Standzeiten kontinuierlich betrieben werden, indem sie einen nach dem anderen die durch den/die jeweilige/n Steuerdatensatz / Steuerdatensätze vorgegebenen individuellen Bauelemente liefert.

Im Gegensatz zu schnell abbindendem Zement, beispielsweise den als Sorel-Zement bekannten Baumaterialien, die durch ihren notwendigerweise hohen Gehalt an MgO sehr teuer sind, werden erfindungsgemäß kostengünstige Naturstoffe oder sogar zu einem negativen Preis verfügbare Materialien (Abfallstoffe unterschiedlicher Branchen) für das Bauwesen genutzt oder sogar überhaupt erst zur Nutzung erschlossen.

### Figurenkurzbeschreibung

Die beiliegenden Zeichnungen veranschaulichen Ausführungsformen und dienen zusammen mit der Beschreibung der Erläuterung der Prinzipien der Erfindung. Die Elemente der Zeichnungen sind relativ zueinander und nicht notwendigerweise maßstabsgetreu. Gleiche Bezugszeichen bezeichnen entsprechend ähnliche Teile.
**Figur 1** zeigt schematisch ein Bauelement gemäß einer Ausführungsform.
**Figur 2** zeigt schematisch ein Bauelement einer anderen Ausführungsform.
**Figur 3** zeigt schematisch ein Detail einer Wand.
**Figur 4** zeigt eine perspektivische Ansicht eines Bauelements gemäß einer weiteren Ausführungsform.
**Figur 5** zeigt zwei Draufsichten desselben Bauelements, einmal des realen Bauelements (5A) und des virtuellen Bauelements (5B), direkt wiedergegeben an Hand des Steuerdatensatzes.
**Figur 6** zeigt, der **Fig. 5** vergleichbar, die schmale Seitenfläche des Bauelements einer Ausführungsform.
**Figur 7** zeigt eine Ansicht der bereits besprochenen Ausführungsform des Bauelements von unten in der, im entsprechenden STL-file hinterlegten "virtuellen" Form.
**Figur 8** zeigt einen Verband, bzw. einen Teil einer Wand, umfassend individuelle Bauelemente.
**Figur 9** zeigt denselben Abschnitt einer Wand, gebildet aus individuellen Bauelementen mit Verschränkungsstrukturen.
**Figur 10** ist eine Detailansicht einer Seitenfläche eines Bauelements im montierten Zustand.
**Figur 11** zeigt einen Verband eines aus neun Bauelementen aufgebauten Wandabschnitts.
**Figur 12** illustriert die hier vorgeschlagene Prozesskette, bzw. das vorgeschlagene Verfahren zur Errichtung einer Wand.
**Figur 13** zeigt schematisch das vorgeschlagene Gebäudeherstellungsverfahren, umfassend das Wandherstellungsverfahren und das Errichten des Rohbaus.

### Ausführliche Erläuterung der Figuren

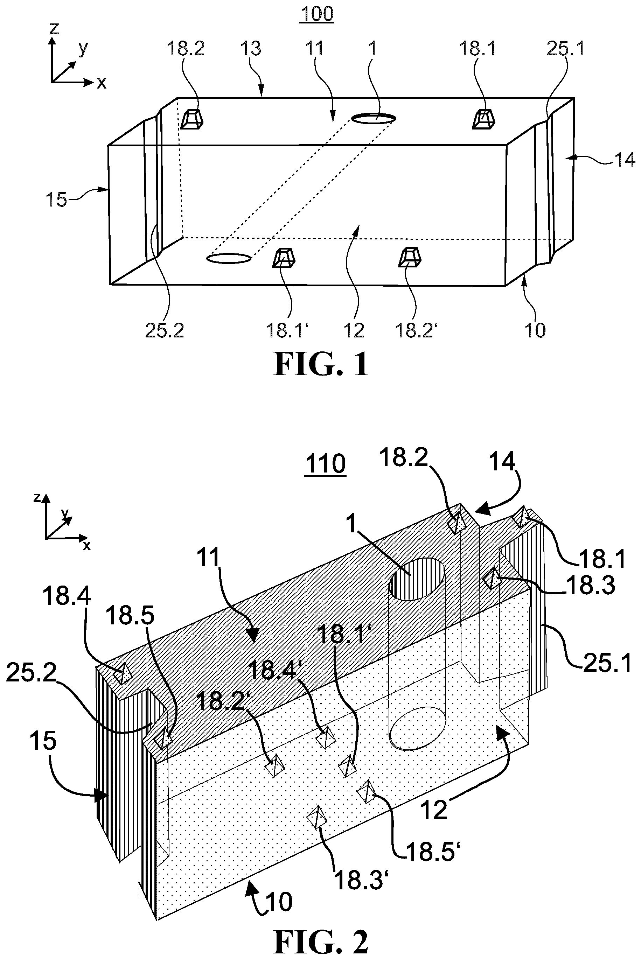

Insbesondere zeigt **Fig. 1** ein Bauelement 100 gemäß einer Ausführungsform. Das Bauelement 100 umfasst einen Abschnitt eines Installationskanals 1 der schräg in der Matrix des Bauelements angeordnet ist. Die hier grundsätzliche Quaderform bedingt neben der Basis 10 bzw. Stellfläche 10 und der Deckfläche 11 die beiden Seitenflächen 12 und 13 mit den hier kleineren Seitenflächen 14 und 15, bzw. erste Stirnfläche 14 und zweite Stirnfläche 14. Die auf der Oberseite bzw. Deckfläche 11 des Bauelements angeordneten Noppen 18.1 und 18.2 greifen bei sachgerechter Montage in korrespondierende Ausnehmungen 18' der im Verband der Wand über dem gezeigten Bauelement 100 angeordneten Bauelemente ein. Dementsprechend bilden die im gezeigten Bauelement 100 in dessen Stellfläche 10 unterseitig angeordneten Ausnehmungen 18.1' und 18.2' mit entsprechenden Noppen der unter dem gezeigten Bauelement 100 angeordneten zwei anderen Bauelemente jeweils einen Eingriff aus, der den so ausbildbaren Verband 200, 300, 300a bzw. die Wand 200, 300, 300a stabilisiert. Vorteilhaft stabilisiert das die Wand 200, 300, 300a. Es ist klar ersichtlich, dass der Installationskanalabschnitt 1 der unten und oben vom gezeigten Bauelement 100 benachbarten weiteren Bauelemente anders, bzw. lateral versetzt verläuft. Um eine Fehlmontage unter Verschluss des beabsichtigten Installationskanals 1 zu vermeiden, können die Noppen, bzw. Erhabenheiten oder Vorsprünge 18.1, 18.2, ... und ihnen zugeordnete Ausnehmungen 18.1', 18.2', ... in den Bauelementen der jeweils benachbarten Bauelement-Schichten unregelmäßig, aber eineindeutig passend zueinander angeordnet werden. Die Anordnung der Erhabenheiten (Noppen, Stümpfe, Ausstülpungen etc.) und korrespondierender Ausnehmungen von zwei benachbarten Bauelementen ähnelt den von einem 3d-Puzzle bekannten eineindeutig zueinander korrespondieren Passungen von unmittelbar benachbarten Puzzle-Teilen.......

**Fig. 2** zeigt schematisch ein Bauelement 110 einer weiteren Ausführungsform mit einem vertikal verlaufendem Kanalabschnitt 1. Die Verankerungselemente 25.1 und 25.2 haben hier eine etwas andere Gestalt, als in der zuvor beschriebenen Ausführungsform 100. Sie sind angepasst, einen der Nut-Feder-Passung vergleichbaren Eingriff auszubilden. Selbstredend können auch die ersten und zweiten Verankerungsstrukturen 25.1 und 25.2 jeweils seitlich benachbarter Bauelemente so gestaltet sein, wie für die Noppen und Ausnehmungen soeben beschrieben, sodass zusätzlich durch diese Merkmale eine fehlerhafte Montage der Bauelemente 100, 110, sowie der nachfolgend noch beschriebenen anderen Ausführungsformen 120, 130, und 150 vermeidbar ist. Wie erkennbar, greifen hier die auf der Deckfläche 11 angeordneten Noppen 18.1, 18.2, 18.3 18.4 und 18.5 in korrespondierende Ausnehmungen der jeweils oben angeordneten den Bauelementverband ausbildenden Bauelemente ein, während die in der Stellfläche 10 angeordneten Ausnehmungen 18.1', 18.2', 18.3', 18.4' und 18.5' ihnen hinsichtlich Größe, Form und Lokalisation entsprechende Erhabenheiten 18, 18.1, 18.2, 18.3, 18.4, 18.5...in Deckflächen der unter dem Bauelement 110 angeordneten Bauelemente aufnehmen. Selbstredend ist in den darüber und darunter in der Wand benachbarten Bauelementen der Kanalabschnitt 1 im Vergleich zu dem in dieser Figur gezeigten Kanalabschnitt 1 jeweils versetzt im jeweils betreffenden Bauelement angeordnet, sodass in der ausgebildeten Wand 200, 300, 300a ein durchgehender Kanal 1 erhalten wird.

**Fig.** 3 zeigt schematisch einen Wandabschnitt 200, bzw. einen Verband 200 umfassend einen Installationskanal 1. Das Detail der Wand 200 kann beispielsweise als perspektivische Ansicht der Außenseite einer Wand 200 angesehen werden. Der Ausschnitt oder gezeigte Verband 200 umfasst 20 Bauelemente 130, 140, 150, 160 (andere sind nicht gesondert gekennzeichnet), wobei hier eine Vielzahl von fünf Bauelementen 130, 140, 150 den gezeigten Installationskanalabschnitt 1 ausbildet. Die in jeweils einer Schicht oder Lage benachbart zueinander angeordneten Bauelemente stehen über entsprechende Verschränkungselemente 25.1, 25.3 jeweils paarweise miteinander im Eingriff. Noppen und korrespondierende Ausnehmungen sind im Interesse der Übersichtlichkeit hier nicht dargestellt. Das unterste Bauelement 150 der den Kanalabschnitt 1 ausbildenden Bauelemente weist eine in einer Seitenfläche 12, 13 ausgebildete Öffnung seines Abschnitts des Installationskanals 1 auf. Der Installationskanalabschnitt 1 dieses Bauelements 150 umfasst beispielsweise ein "Knie" des Installationskanalabschnitts 1, das eine Krümmung des Kanals 1 um 90° bewirkt. Die Öffnung in der Seitenfläche 12, 13 ist zumindest mit ihrem Innendurchmesser und eventuell zumindest abschnittsweise darin anordenbaren Dichtelementen angepasst zum Anschluss des Installationskanals 1 der Wand 200 an eine externe Versorgungsleitung 50. Zwischen den Bauelementen 130, 140, 150, 160, .... ausgebildete Fugen können mit einem Adhäsiv gefüllt sein, das den Verband stabilisiert. Gemäß der bereits oben beschriebenen Ausführungsform kann der sich in einer Seitenfläche der Wand öffnende Installationskanalabschnitt 1 auch in eine Öffnung bzw. Ausnehmung größeren Durchmessers und größerer Querschnittsfläche übergehen und so beispielsweise als eine Verteilerbox dienen. Mit einem Deckel abgedeckt und so im Wesentlichen bündig mit der Wand 200 verschlossen, bleibt der zumindest eine Installationskanal oder bleiben mehrere in diese größere Ausnehmung einmündenden Installationskanäle 1 von außen zugänglich.

Die für die Versorgungsleitung 50 notwendige Öffnung in der Wand, kann auch direkt mit der Wand abschließen und stellt dann beispielsweise eine von außen zugängliche Verteilerbox für elektrische Anschlüsse dar, die dann mit einem Deckel, vorzugsweise aus Kunststoff, abgedeckt wird und somit dauerhaft zugänglich bleibt. Die Verteilerbox kann als Schnittstelle einer Vielzahl von Installationskanälen dienen, in denen elektrische Leitungen geführt werden. Der Querschnitt der Öffnung kann vorzugsweise rund, quadratisch oder rechteckig geformt sein. Die Öffnung ist so dimensioniert, dass sie genügend Platz bietet, so dass Kabel mit Klammern verbunden sein können. Ebenfalls können vorzugsweise runde Boxen als Aufnahme für Steckdosen oder für Schalter in Verbindung mit Leitungskanälen bzw. Versorgungsleitungen dienen.

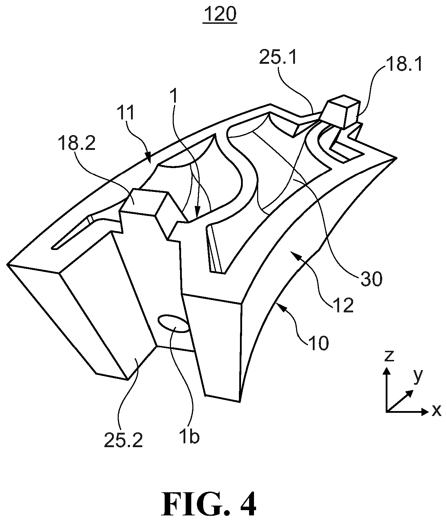

**Fig.** 4 zeigt eine perspektivische Ansicht eines Bauelements 120 einer weiteren Ausführungsform. Gut sichtbar ist die Gyroidstruktur 30 der Verankerung des Installationskanalabschnitts 1 im Inneren des Bauelements 120. Eine kreisrunde Querschnittsfläche 1b des Installationskanals 1 schließt den Kanalabschnitt in einer zur Verankerung dienenden Struktur 25.2 des Bauelements 120, das einer gewölbte Seitenfläche 12 aufweist, ab. Die Verankerungsstruktur 25.2 ist hier in Form einer "Nut" ausgebildet. Auf der gegenüberliegenden schmalen Seitenfläche 14, bzw. Stirnfläche 14 des Bauelements 120 ist die entsprechende, einer "Feder" vergleichbaren Verankerungsstruktur 25.1 ausgebildet. Nut und Feder von in einer Wand unmittelbar benachbarten Bauelementen stehen im Eingriff miteinander. An der Oberseite, der Deckfläche 11 des Bauelements 120 sind jeweils Erhabenheiten bzw. Noppen 18.1 und 18.2 ausgebildet. Diese Noppen oder Stümpfe 18.1, 18.2 sind hinsichtlich ihrer Lokalisation - entweder auf der Deckfläche 11 oder unmittelbar auf der oberen Fläche der anschließenden seitlichen Verankerungsstrukturen 25.1, 25.2 - hinsichtlich ihrer Größe und hinsichtlich ihrer Form angepasst, mit einer oder mehreren entsprechenden Ausnehmungen 18' an einer Unterseite 10 eines oder mehrerer des/der darüber angeordneten Bauelements/Bauelemente des Wandverbands ebenfalls Eingriffe auszubilden. Auch diese miteinander im losen Eingriff stehenden Strukturen 25.1, 25.2 können vorteilhaft zusätzlich durch ein Adhäsiv fixiert werden. Durch die mittels einer Gyroidstruktur 30 im Inneren des Bauelements 120 freitragende Anordnung des Kanalabschnitts 1 erscheint die Deckfläche 11 dieses Bauelements 120 nicht als geschlossene sondern als zerklüftete Fläche 11. Die großen Seitenflächen 12 und 13 (nicht gekennzeichnet) sind jeweils konkav, bzw. konvex gekrümmt/ gewölbt.

Neben der hier gezeigten Nut-Feder-Verbindung umfassend einen "Schlitz" 25.2 und einen "Zapfen" 25.1, sind auch andere Verankerungsstrukturen 25 möglich. Ein Beispiel ist eine Schwalbenschwanzverbindung. Alternativ können auch andere, z.B. aus der Tischlerei bekannte Formen von Langholzverbindungen, wie z.B. eine Überplattung, ein Keilverschluss, oder eine Keilzinkenverbindung genutzt werden. Typischerweise wird hierbei die Ausbildung eines Spalts / einer Fuge für das jeweils verwendete Adhäsiv vorgesehen, indem die betreffenden Maße, typischerweise Länge, Breite und Höhe der einzelnen Bauelemente entsprechend reduziert werden.

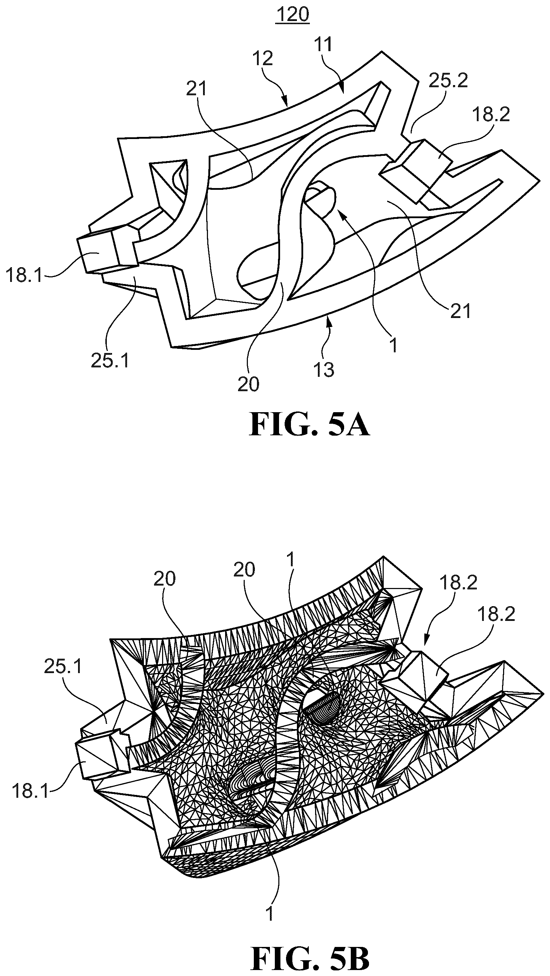

**Fig. 5A** zeigt das additiv gefertigte Bauelement, **Fig. 5B** zeigt das mittels dem zugehörigen STL-Datei im entsprechenden Steuerdatensatz hinterlegte "virtuelle" Bauelement 120. Die in der **Fig. 5B** erkennbare und dem Fachmann vertraute "Netzstruktur" erleichtert dem Betrachter die Unterscheidung des Installationskanalabschnitts 1 von der diesen tragenden Gyroidstruktur 20. In beiden Teilansichten ist erkennbar, dass die Gyroidstruktur an der Ausbildung der Deckfläche 11 und der Stellfläche 10 beteiligt ist. Die durch die Gyroidstruktur 20 ausgebildeten Hohlräume 21 ermöglichen für jedes der Bauelemente ein vollständiges depowdering, wenn das Bauelement additiv in einem pulverbasierten Verfahren 1000 gefertigt wird. Andererseits ermöglichen die Hohlräume 21 vorteilhaft eine Materialersparnis, wenn das Bauelement 120 beispielsweise in einem filamentbasierten Fertigungsverfahren 1040 hergestellt wird. Gut sichtbar sind die relativ simplen Noppen 18.1 und 18.2, die gekrümmten Seitenwände 12 und 13 und die der Deckfläche 11 zuzuordnenden Gyroidstrukturen 20. Die zwischen Kanalabschnitt 1 und Gyroidstruktur 20ausgebildeten und sowohl in Fig. 5A und in Figur 5B durchgehend verlaufenden Hohlräume 21 erlauben ein vollständiges Freistellen, z.B. durch Entpulvern, wenn das Bauelement 120 pulverbasiert, d.h. in einem Pulverbett oder in einem Schlickerbett gefertigt wird.

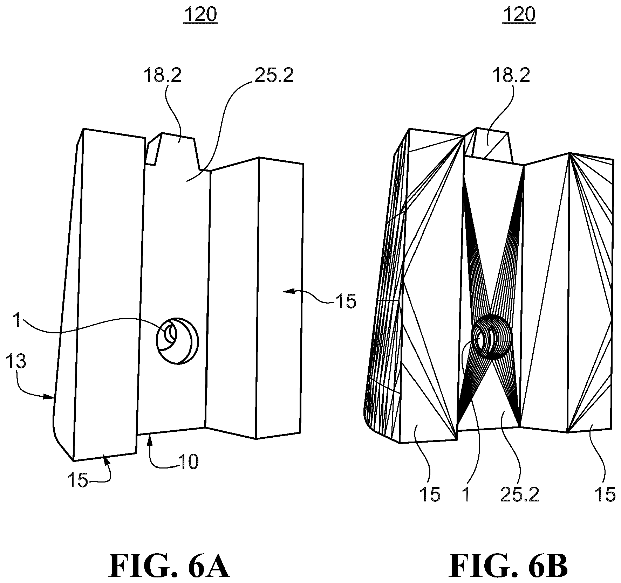

Der vorstehenden Figur vergleichbar, zeigt **Fig. 6** eine Seitenfläche 15 der zwei schmalen Seitenflächen 14, 15 einer Ausführungsform 120 des Bauelements. Es ist ersichtlich, dass der Installationskanalabschnitt 1 im Wesentlichen horizontal und in einem im Wesentlichen konstanten Abstand zu den Außenwänden 13 und 12 (nicht gekennzeichnet) verläuft. Wiederum zeigt die **Fig. 6A** das reale, additiv gefertigte Bauelement 120, während **Fig. 6B** die entsprechende Ansicht des mittels des zugehörigen STL-files im Steuerdatensatz hinterlegte "virtuelle" Bauelement 120 repräsentiert.

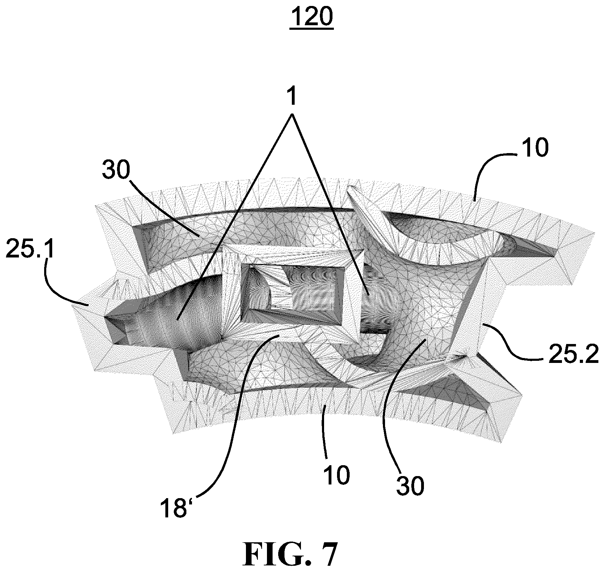

**Fig. 7** zeigt die Ansicht einer der bereits besprochenen Ausführungsform des Bauelements 120 in seiner, im entsprechenden STL-file hinterlegten "virtuellen" Form von seiner Basis 10, bzw. in der zu errichteten Wand als Stellfläche 10 dienenden Grundfläche aus. Hier ist der Installationskanalabschnitt 1 deutlicher als zuvor gegenüber der Unterseite 30 der Gyroidstruktur 30 erkennbar. Ebenso deutlich tritt die hier im Querschnitt rechteckig erscheinende Aufnahme der Noppen 18.1 und 18.2 (hier nicht gezeigt) an der Stellfläche 10 für die unten benachbart anschließenden zwei Bauelemente hervor. Die Noppen 18.1 und 18.2 jeweils lateral benachbart angeordneter Bauelemente 120 werden vom gezeigten rechteckigen Rahmen 18' gefasst bzw. umschlossen. Das verstärkt die Stabilität der aus den korrespondierenden Bauelementen aufgebauten Wand.

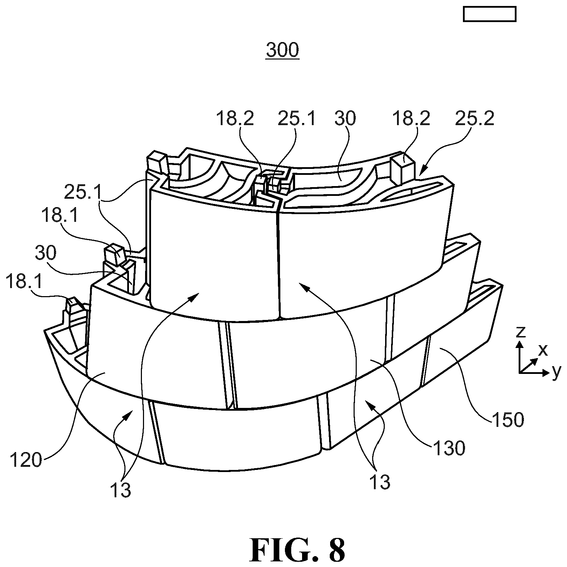

**Fig. 8** zeigt einen Verband 300, bzw. einen Teil einer Wand 300, umfassend individuelle Bauelemente 120, 130, 150 mit Verschränkungselementen 25.1, 25,2, die jeweils Noppen 18.1, 188.2 bzw. Erhabenheiten oder Stümpfe 18.1 und 18.2 aufweisen. Der hier von der Außenseite aus nicht sichtbare Installationskanal 1 bzw. dessen Abschnitt 1 verläuft in der mittleren Schicht oder Lage des Verbandes 300, die die Bauelemente 120 und 130 umfasst. Die Bauelemente 300 in der untersten und in der obersten Lage weisen keine Installationskanalabschnitte auf, haben aber wie erkennbar, auch eine innere Gyroidstruktur 30, die das Depowdering bei einer pulverbasierten Fertigung bzw. eine Materialersparnis und Nachhaltigkeit unabhängig vom konkreten Verfahren der additiven Fertigung ermöglicht.

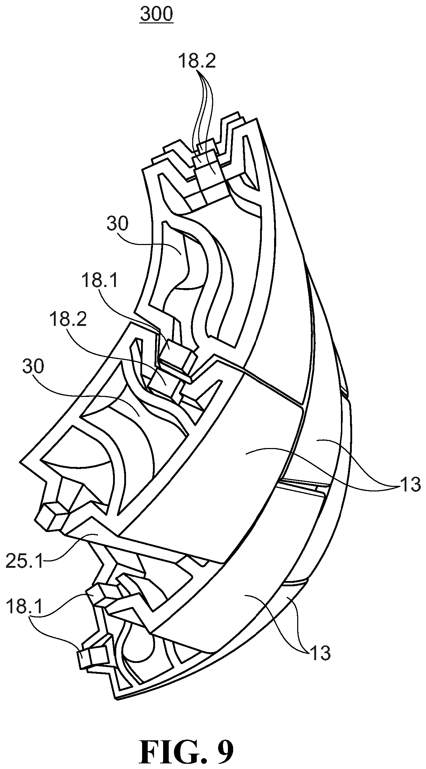

**Fig. 9** zeigt denselben Abschnitt einer Wand 300, gebildet aus individuellen Bauelementen umfassend Verschränkungsstrukturen, 25.1, 25.2 und jeweiligen Noppen oder Stümpfe 18.1, 18.2, die im montierten Zustand des Verbandes jeweils durch entsprechende Ausnehmungen 18' an den Unterseiten 10 oberseitig benachbarter Bauelemente gefasst und zusammengehalten werden, sowie die Gyroidstruktur 30 im Inneren der Bauelemente des Verbandes 300. Die Bauelemente der gezeigten Wand 300 bzw. Wandabschnitt 300 weisen jeweils eine konvex geschwungene Außenseite 13 auf.

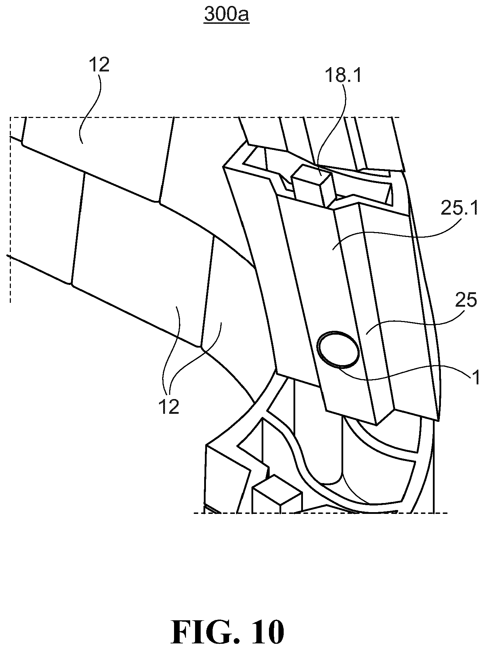

**Fig. 10** ist eine Detailansicht einer Seitenfläche 25 (Flanke) eines Bauelements im montierten Zustand in einer Wand / in einem Verband mit einem Verschränkungselement 25.1 und einer im Verschränkungselement 25.1 angeordneten Kanalöffnung 1. Das gezeigte erste Verschränkungselement 25 weist eine erste Erhabenheit 18.1 an der Oberseite des ersten Verankerungselements 25.1 auf, die gemeinsam mit der Erhabenheit des frontseitig in der Lage (Schicht) benachbarten Bauelements (nicht gezeigt) im Eingriff mit einer Ausnehmung 18' in der Stellfläche 10 des beide Bauelemente darüber verbrückenden Bauelements (nicht gezeigt) stehen. Wie bereits aus vorausgehenden Figuren ersichtlich, sind die Seitenflächen 12, 13 des Bauelements 300, 300a gekrümmt.

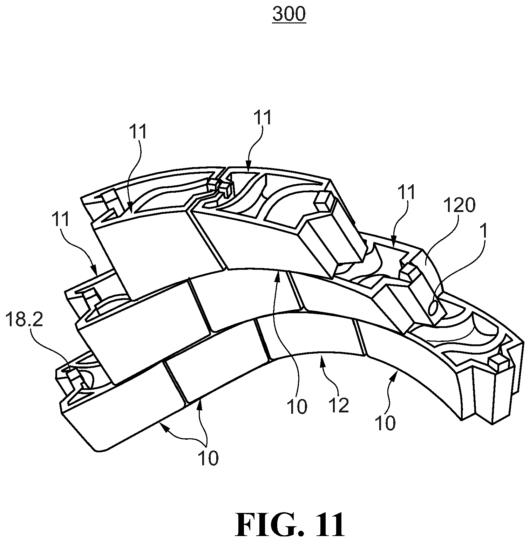

**Fig. 11** zeigt einen Verband 300 eines aus neun Bauelementen aufgebauten Wandabschnitts von der Innenseite 12 der Bauelemente aus gesehen. Das bereits zuvor gezeigte seitlich gekrümmte Bauelement 120 mit der Öffnung 1b des Kanalabschnitts 1 ist in der mittleren Lage des Verbandes 300 angeordnet.

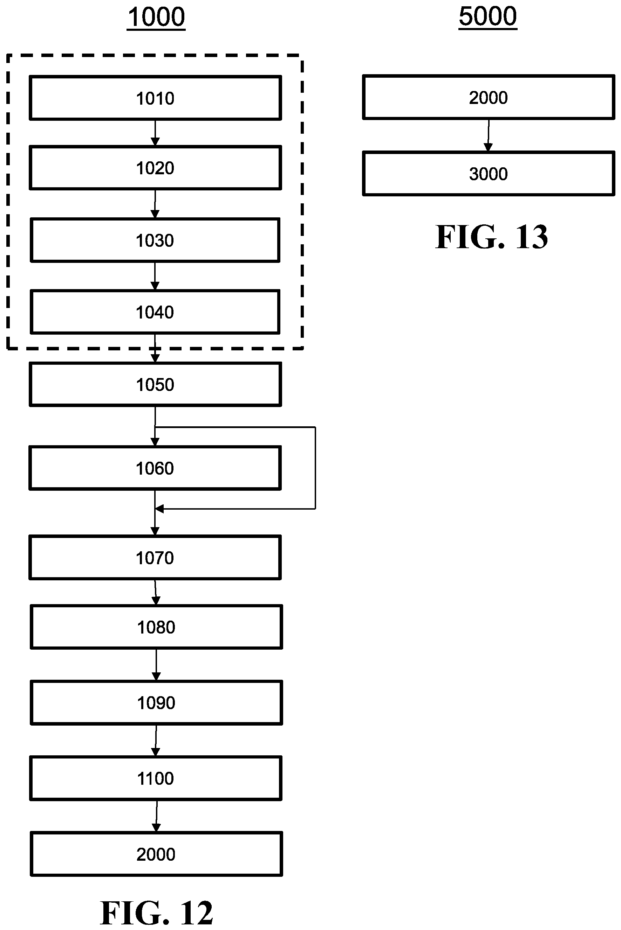

**Fig. 12** illustriert die hier vorgeschlagene Prozesskette, bzw. das vorgeschlagene Verfahren 1000 zur Errichtung einer Wand mit den hier beschriebenen Bauelementen. Die einzelnen Schritte des Verfahrens 1000 umfassen das computergestützte Konstruieren 1010 der Wand, das nachfolgende computergestützte Zerlegen 1020 in einzelne, individuelle Bauelemente, gefolgt vom Erstellen des Steuerdatensatzes 1030, der im Schritt des additiven Fertigens 1040 in / mit einer entsprechenden Vorrichtung, z.B. einem 3D-Druckereiner dafür geeigneten Bauform und entsprechenden Hilfselementen (z.B. Arbeitsraum, Arbeitsplattform, Materialvorratsbehälter, Filament, Filamentschmelzdüse, Pulver, Granulat, Schlicker, evtl. Rakel, evtl. Laser, evtl. Binder-Dosierventil, etc.) zum additiven Aufbau des Bauelements 100, 110, 120, 130, 140, 150, 160.... oder von dessen Rohling 100, 110, 120, 130, 140, 150, 160.... eingesetzt wird. Anschließend erfolgt im Schritt 1050 das Entnehmen aus der Fertigungsvorrichtung, an das sich optional ein Nachbehandeln 1060 anschließen kann.

Somit folgt auf das additive Fertigen 1040 bzw. auf das Nachbehandeln 1050 des additiv gefertigten Bauelements 100, 110, 120, 130, 140, 150, 160.... der Prozessschritt des individuellen Verpackens 1070 der Bauelemente. Im nachfolgenden Schritt 1080 können die verpackten Bauelemente direkt auf einem Transportmittel oder auf einer Zwischenlagerfläche geordnet abgelegt bzw. deponiert werden. Nun schließt sich der Transport 1090 der verpackten Bauelemente 100, 110, 120, 130, 140, 150, 160.... zur Baustelle an. Hier ergeben sich erneut zumindest zwei grundlegende Optionen: Die Bauelemente 100, 110, 120, 130, 140, 150, 160.... werden entweder sofort von dessen Ladefläche / aus dessen Laderaum geordnet auf einer Gründung, beispielsweise einem Fundament der zu errichtenden Wand angeordnet, wodurch unmittelbar die zuvor projektierte Wand errichtet wird. Alternativ dazu können die Bauelemente auch auf einer Baustellenlagerfläche geordnet abgelegt werden, sodass später, ggf. nach vollständigem Ausbilden der Gründung, mit dem Errichten 2000 der Wand 200, 300, 300a oder gar eines kompletten Rohbaus durch ein Rohbauherstellungsverfahren 5000 begonnen wird.

Wie in **Fig. 12** durch das gestrichelte Rechteck dargestellt wird, kann ein computergestütztes Herstellungserfahren gemäß einer Ausführungsform umfassen:
- Konstruieren 1010 mindestens eines Teils eines Bauwerks, insbesondere einer Wand, wobei der mindestens eine Teil 200, 300, 300a einen Installationskanal 1 aufweist,
- Zerlegen 1020 des konstruierten mindestens einen Teils 200, 300, 300a in typischerweise zumindest im Wesentlichen extrusionskörperförmige Bauelemente 100, 110, 120, 130, 140, 150, 160...., wobei mindestens zwei, typischerweise eine Vielzahl zumindest paarweise zueinander benachbarter Bauelemente 100, 110, 120, 130, 140, 150, 160.... zumindest einen jeweiligen Abschnitt des Installationskanals 1 aufweisen;
- Erstellen 1030 eines Steuerdatensatzes zur Steuerung einer Vorrichtung 500 zur additiven Fertigung, die konfiguriert ist, aus zumindest einem Baustoff die Vielzahl der Bauelemente 100, 110, 120, 130, 140, 150, 160.... individuell bereitzustellen; und
- Fertigen 1040 der Vielzahl der Bauelemente 100, 110, 120, 130, 140, 150, 160.... mittels der Vorrichtung 500 zur additiven Fertigung unter Verwendung des Steuerdatensatzes.

**Fig. 13** ist ein Blockschema des Gebäudeherstellungsverfahren 5000, das die Verfahrensschritte "Herstellen der Wand" 2000 und "Errichten eines Rohbaus" 3000, umfassend die Wand 200, 300, 300a umfasst.

Das eingangs beschriebene und vorstehend bereits erläuterte additive Fertigen umfasst ein typischerweise selbständig erfolgendes Verfestigen der unmittelbar zuvor gefertigten Bauelemente 100, 110, 120, 130, 140, 150, 160.... bis zu einer bestimmungsgemäßen Endfestigkeit. Diese kann erreicht werden durch eines oder mehrere von: Aushärten, Abkühlen, Erstarren, Abbinden und/oder Trocknen, Durchpolymerisieren oder Sintern des jeweils verwendeten und ggf. - wie vorstehend beschrieben ggf. nur lokal behandelten Baustoffs und/oder ein Freistellen des in einem Pulverbett erzeugten Bauelements 100, 110, 120, 130, 140, 150, 160..... Unter dem Freistellen wird hier wie fachüblich ein Entfernen des nicht zu einem Bestandteil des Bauelements verfestigten Pulvers verstanden. Das genannte Aushärten, Abkühlen, Erstarren, Abbinden und/oder Trocknen, Durchpolymerisieren und/oder Sintern des der Fertigungsvorrichtung unmittelbar entnommenen Bauelements erfolgt gemäß typischer Ausführungsformen, indem das Bauelement oder dessen Rohling auf der Arbeitsplattform verbleibt. Unter dem "Durchpolymerisieren" wird hierbei das vollständige Polymerisieren des möglicherweise zunächst nur äußerlich polymerisierten Baumaterials verstanden. Das frisch gefertigte Bauelement 100, 110, 120, 130, 140, 150, 160....wird hierzu zusammen mit der Arbeitsplattform der Vorrichtung entnommen. Das hat den Vorteil, das noch nicht ausgehärtete, noch heiße, noch nicht erstarrte, noch nicht vollständig abgebundene, durchpolymerisierte, noch feuchte oder noch ungesinterte Bauelemente 100, 110, 120, 130, 140, 150, 160.... berührungsfrei transportieren oder einfach umsetzen zu können.

Mit anderen Worten ausgedrückt, kann das der Vorrichtung entnommene Bauelement 100, 110, 120, 130, 140, 150, 160.... - abhängig vom jeweils verwendeten Baustoff - mithin nicht sofort gebrauchsfertig sein. Erforderlichenfalls kann das Bauelement 100, 110, 120, 130, 140, 150, 160.... deshalb einer Nachbearbeitung 1060 oder Nachbehandlung 1060 unterzogen werden. Eine solche Nachbearbeitung 1060 ist typischerweise ausgewählt unter einem Sintern, insbesondere im Fall seines vorausgehenden Freistellens aus einem Pulverbett. Weiter kann das Nachbehandeln bzw. eine Nachbearbeitung auch ausgewählt sein unter einem zumindest einseitigen, einem nur abschnittsweisen oder einem vollständigen Benetzen, beispielsweise mit einer Farbe, einem Verwitterungsschutzmittel, oder einem Benetzen durch Imprägnieren mit einem wasserabweisenden Imprägniermittel oder mit einem Binder zur Festigkeitssteigerung. Imprägniermittel sowie Binder können sowohl flüssig als auch gasförmig appliziert werden. Das beschriebene Imprägnieren kann beispielsweise eine äußere Oberfläche oder einen Porenraum wasser- und/oder schmutzabweisend machen oder, beispielsweise den Installationskanalabschnitt 1 des Bauelements 100, 110, 120, 130, 140, 150, 160.... undurchlässig für ein darin zu transportierenden Medium machen. Auf diese Art und Weise wird der betreffende Installationskanalabschnitt 1 des Bauelement 100, 110, 120, 130, 140, 150, 160....als Rohrabschnitt 1 zur Führung eines Fluids im resultierenden Installationskanal 1 verwendbar gemacht.

Zusätzlich beinhaltet die Nachbearbeitung die Markierung oder Codierung jedes einzelnen Bausteins, so dass er somit einer eineindeutigen Position in der Wand oder dem Bauwerk zugeordnet ist, auch wenn er sich noch nicht an der tatsächlichen Position in der Wand befindet.

Dem zuvor für pulverbasiert gefertigte Bauelemente 100, 110, 120, 130, 140, 150, 160 ... beschriebenen Sintern kann erforderlichenfalls ein sogenanntes "Entpulvern" (engl.-depowdering) und/oder Entbindern vorausgehen. Dabei werden nicht verfestigte Bestandteile eines Pulverbetts und/oder als Binder eingesetzte Substanzen, die noch im Rohling des Bauelements 100, 110, 120, 130, 140, 150, 160 ... verblieben sind, entfernt. Das Entbindern kann beispielsweise durch Pyrolyse oder durch die Einwirkung von Binder-Lösungsmitteln erfolgen.

Das beschriebene Sintern eines Rohlings (z.B. "Grünkörpers") des Bauelements 100, 110, 120, 130, 140, 150, 160.... kann wie fachüblich über die Passage eines kontinuierlichen Ofens, bzw. eines Rollenofens erfolgen. Dabei wird ein langgestreckter Ofen, der ggf. unterschiedlich temperierte Zonen aufweist, kontinuierlich von einer Folge nacheinander gefertigter Bauelement-Rohlinge auf einem Transportband / auf Rollen oder Ähnlichem / durchlaufen. Die Bauelemente 100, 110, 120, 130, 140, 150, 160.... sind dabei beispielsweise noch auf ihren jeweiligen Arbeitsplattformen angeordnet. Der Ofen kann so ausgelegt sein, dass kontinuierlich ein Trockenen, Entbindern, Sintern und/oder andere Schritte erfolgen, die zum Erreichen der Endfestigkeit des Bauelemente 100, 110, 120, 130, 140, 150, 160.... und damit zu dessen bestimmungsgemäßer Verwendbarkeit führen. Die soeben bezeichneten Schritte werden selbstredend einem individuellen Verpacken der Bauelemente vorangestellt. Während dieser Nachbehandlungsschritte kann die verwechslungssichere Identifikation der verschiedenen Bauelemente 100, 110, 120, 130, 140, 150, 160.... über eine Kennzeichnung ihrer jeweiligen Arbeitsplattformen gewährleistet sein.

Wenngleich hierin spezifische Ausführungsformen dargestellt und beschrieben worden sind, liegt es im Rahmen der vorliegenden Erfindung, die gezeigten Ausführungsformen geeignet zu modifizieren, ohne vom Schutzbereich der vorliegenden Erfindung abzuweichen. Die nachfolgenden Ansprüche stellen einen ersten, nicht bindenden Versuch dar, die Erfindung allgemein zu definieren.

### Bezugszeichenliste

- 1: Kanal, Kanalabschnitt
- 1b: Kanalabschnittsöffnung, kreisförmiger Querschnitt
- 10: Basis, Stellfläche
- 11: Deckfläche
- 12: erste Seitenfläche
- 13: zweite Seitenfläche
- 14: erste Stirnfläche, dritte Seitenfläche
- 15: zweite Stirnfläche, vierte Seitenfläche
- 18: Noppe, Erhabenheit, Stumpf
- 18': Ausnehmung zur Aufnahme von 18
- 18.1: erste Noppe, erste Erhabenheit, erster Stumpf
- 18.1': Ausnehmung zur Aufnahme von korrespondierender 18.1 eines benachbarten Bauelements
- 18.2: zweite Noppe, ...Erhabenheit, ...Stumpf, ...Vorsprung, ...Ausstülpung
- 18.2': Ausnehmung zur Aufnahme von korrespondierender 18.2 eines benachbarten Bauelements
- 18.3: dritte Noppe, ...Erhabenheit, ...Stumpf, ...Vorsprung, ...Ausstülpung
- 18.3': Ausnehmung zur Aufnahme von korrespondierender 18.3 eines benachbarten Bauelements
- 18.4: vierte Noppe, ...Erhabenheit, ...Stumpf, ...Vorsprung, ...Ausstülpung
- 18.4': Ausnehmung zur Aufnahme von korrespondierender 18.4 eines benachbarten Bauelements
- 18.5: fünfte Noppe, ...Erhabenheit, ...Stumpf, ...Vorsprung, ...Ausstülpung
- 18.5': Ausnehmung zur Aufnahme von korrespondierender 18.5 eines benachbarten Bauelements
- 20, 21, 30: interne Stützstruktur, z.B. hier Gyroidstruktur
- 25: Verschränkungselement Eingriff ausbildend, z.B. Schwalbenschwanz ...
- 25.1: erstes Verschränkungselement, z.B. "Feder"
- 25.2: zweites Verschränkungselement, z.B. "Nut"
- 50: Versorgungsleitung, extern; z.B. Rohrstutzen
- 100, 110, 120, 130, 140, 150, 160: Bauelement unterschiedlicher Ausführungsformen
- 200: Verband / Wandausschnitt / mit angeschlossener Versorgungsleitung 50
- 300: Bauelemente-Verband, Ausschnitt einer Wand, Fig. 8: Frontal- / z.B. Außenansicht; Fig. 9: Draufsicht
- 300a: Bauelemente-Verband, Ausschnitt einer Wand, Fig. 10 Detail einer Seitenansicht / z.B. Ansicht von innen des (zukünftigen) Rohbaus
- 500: Vorrichtung zur additiven Bauelementfertigung
- 1000: Verfahren zum Herstellen bzw. zum Errichten einer Wand
- 1010: Verfahrensschritt computergestütztes Konstruieren der Wand
- 1020: Verfahrensschritt computergestütztes Zerlegen der konstruierten Wand in virtuelle Bauelemente
- 1030: Verfahrensschritt Erstellen von Steuerdatensätzen
- 1040: Verfahrensschritt additives Fertigen der individuellen Bauelemente der Wand
- 1050: Verfahrensschritt Entnehmen der Bauelemente aus der Fertigungsvorrichtung
- 1060: Verfahrensschritt Nachbehandeln, z.B.: thermisch, mechanisch, Abbinden, Erstarren, Durch-Polymerisieren, Trocknen, Sintern, Imprägnieren, Einfärben, Beschichten, Polieren....
- 1070: Verfahrensschritt Individuelles Verpacken von Bauelementen
- 1080: Verfahrensschritt Geordnetes Deponieren von Bauelementen
- 1090: Verfahrensschritt Transportieren von Bauelementen
- 1100: Verfahrensschritt Ausbilden eines Verbandes von Bauelementen
- 2000: Errichten der Wand, Montage der Bauelemente zur Wand, ggf. mit Verfugen
- 3000: Rohbauherstellungsverfahren unter Verwendung zumindest einer Wand
- 4000: Bausatz umfassend Bauelemente einer Wand oder eines Gebäuderohbaus, Kit
- 5000: Gebäudeherstellungsverfahren
- x₁₀, y₁₀: äußere Konturen der Stellefläche eines Bauelements
- x₁₀, y₁₀: äußere Konturen der Deckfläche eines Bauelements
- z: vertikale Richtung

### Ausführungsformen

1. Verfahren (1000) zur Herstellung einer Wand (200, 300, 3000a), aufweisend die Prozesse:
   - computergestütztes Konstruieren (1010) der Wand (200, 300, 300a), wobei die Wand (200, 300, 300a) einen Installationskanal (1) aufweist,
   - computergestütztes Zerlegen (1020) der konstruierten Wand (200, 300, 300a) in Bauelemente (100, 110, 120, 130, 140, 150, 160....),
      wobei eine Vielzahl zueinander benachbarter Bauelemente (100, 110, 120, 130, 140, 150, 160....) zumindest einen Abschnitt des Installationskanals (1) umfasst;
   - computergestütztes Erstellen (1030) eines Steuerdatensatzes zur Steuerung einer Vorrichtung (500) zur additiven Fertigung, die konfiguriert ist, aus zumindest einem Baustoff die Vielzahl der Bauelemente (100, 110, 120, 130, 140, 150, 160....) individuell bereitzustellen;
   - additives Fertigen (1040) der Vielzahl der Bauelemente (100, 110, 120, 130, 140, 150, 160....) für die Wand (200, 300, 300a) mit der Vorrichtung (500) zur additiven Fertigung unter Verwendung des Steuerdatensatzes; und typischerweise
   - Errichten der Wand (1100) durch ein geordnetes Fügen der Vielzahl der gefertigten Bauelemente (100, 110, 120, 130, 140, 150, 160....) umfassend ein Ausbilden eines Verbandes (200, 300, 300a) der Bauelemente 100, 110, 120, 130, 140, 150, 160....).
2. Verfahren (1000) nach Ausführungsform 1, wobei das computergestützte Zerlegen (1020) der konstruierten Wand (200, 300, 300a) in Bauelemente (100, 110, 120, 130, 140, 150, 160....) schichtweise in zueinander benachbarte Schichten erfolgt, und ein anschließendes Aufteilen (1025) jeder dieser Schichten in eine Abfolge von Bauelementen (100, 110, 120, 130, 140, 150, 160....), umfassend die Vielzahl benachbarter Bauelemente (100, 110, 120, 130, 140, 150, 160....) umfasst.
3. Verfahren (1000) nach Ausführungsform 2,
   wobei das Aufteilen (1025) der zueinander benachbarten Schichten in Bauelemente (100, 110, 120, 130, 140, 150, 160....) so erfolgt, dass im Wesentlichen vertikal angeordnete Flächen (14, 15) der Bauelemente (100, 110, 120, 130, 140, 150, 160....) benachbarter Schichten, die eine Wandfläche ausbilden, versetzt zueinander verlaufen.
4. Verfahren (1000) nach einer der vorstehenden Ausführungsformen, wobei das computergestützte Erstellen (1030) des Steuerdatensatzes und das additive Fertigen (1040) angepasst sind, den Abschnitt des Installationskanals (1) mit zumindest zwei Öffnungen zu versehen, wobei eine Ebene einer ersten Querschnittsendfläche des Abschnitts des Installationskanals (1) im Wesentlichen parallel oder im Wesentlichen orthogonal zu einer Ebene einer zweiten Querschnittsendfläche des Abschnitts des Installationskanals (1) des gefertigten Bauelements (100, 110, 120, 130, 140, 150, 160....) orientiert ist.
5. Verfahren (1000) nach einer der vorstehenden Ausführungsformen,
   - wobei beim Ausbilden des Verbandes (1100) benachbarte Bauelemente (100, 110, 120, 130, 140, 150, 160...) mit einem Adhäsiv fixiert werden.
6. Verfahren (1000) nach einer der vorstehenden Ausführungsformen,
   wobei der Installationskanal (1) konfiguriert ist für eine Installation eines Kabels, eines Rohres und/oder für den Transport eines Fluids.
7. Verfahren (1000) nach einer der vorstehenden Ausführungsformen, wobei die Vielzahl der Bauelemente (100, 110, 120, 130, 140, 150, 160.... ) zumindest 3, bevorzugt 3 bis 1 Million, weiter bevorzugt 10 bis 50.000 Stück umfasst.
8. Verfahren (1000) nach einer der vorstehenden Ausführungsformen,
   wobei die gefertigten Bauelemente (100, 110, 120, 130, 140, 150, 160....) im Wesentlichen quaderförmig sind und/oder sich auf eine oder mehrere quaderförmige Grundformen zurückführen lassen, und
   wobei die gefertigten Bauelemente (100, 110, 120, 130, 140, 150, 160....) typischerweise an einander gegenüberliegenden Seiten Verankerungsstrukturen (25.1, 25.2) aufweisen, die durch ihre jeweilige Größe, Form und Position so konfiguriert sind, dass zumindest abschnittsweise ein Eingriff ausbildbar ist einer ersten Verankerungsstruktur (25.1) eines ersten Bauelements (100, 110, 120, 130, 140, 150, 160....) mit einer zweiten Verankerungsstruktur (25.2) eines in der Wand (200, 300, 300a) benachbarten zweiten Bauelements (100, 110, 120, 130, 140, 150, 160....).
9. Verfahren (1000) nach einer der vorstehenden Ausführungsformen, weiter aufweisend:
   - individuelles Verpacken (1070) aller oder zumindest der Vielzahl der Bauelemente (100, 110, 120, 130, 140, 150, 160.... ) mit einem Verpackungsmaterial.
10. Verfahren (1000) nach einer der vorstehenden Ausführungsformen,
   wobei das computergestütztes Zerlegen (1020) der konstruierten Wand (200, 300, 300a) in die Bauelemente (100, 110, 120, 130, 140, 150, 160....) so erfolgt, dass deren jeweilige Masse zwischen 1 kg und 25 kg, bevorzugt zwischen 5 kg und 10 kg beträgt.
11. Verfahren (1000) nach einer der vorstehenden Ausführungsformen, weiter aufweisend:
   - Markieren (1200) der Bauelemente (100, 110, 120, 130, 140, 150, 160....) mit einem ihre jeweilige Position in der Wand (200, 300, 300a) kennzeichnenden individuellen Code.
12. Verfahren (1000) nach einer der vorstehenden Ausführungsformen,
   wobei das additive Fertigen (1040) mit einem Baustoff erfolgt, umfassend: einen Beton, einen Mörtel, einen Lehm, einen Ton, ein Alumosilikat, eine kieselsäurehaltige Verbindung, ein Metakaolin, ein organisches Polymer, ein vernetzungsfähiges Monomer, ein Puzzolan und/oder ein zu einer Geopolymerbildung geeignetes Materialgemisch.
13. Verfahren (1000) nach einer der vorstehenden Ausführungsformen, wobei bei dem additiven Fertigen (1040) in den Bauelementen (100, 110, 120, 130, 140, 150, 160.... ) ein Gradient einer relativen Konzentration einer Baustoffart, einer Baustoffdichte, einer Porosität, einer Pigmentierung, einer Benetzbarkeit, einer Wärmeleitfähigkeit, und/oder einer Schalldämmwirkung erzeugt wird, wobei der Gradient im Wesentlichen orthogonal zu einer Fläche der Wand (200, 300, 300a) orientiert ist.
14. Verfahren (1000) nach einer der Ausführungsformen 11 bis 13, weiter aufweisend die Prozesse:
   - automatisches Aufnehmen und Anordnen der Vielzahl Bauelemente (100, 110, 120, 130, 140, 150, 160....) auf einem Transportmittel;
   - Transportieren (1090) der auf dem Transportmittel angeordneten Vielzahl Bauelemente (100, 110, 120, 130, 140, 150, 160....) zu einer Baustelle;
   - Entladen des Transportmittels umfassend ein geordnetes Absetzen der Vielzahl Bauelemente (100, 110, 120, 130, 140, 150, 160....) auf einer Lagerfläche entsprechend ihrer durch den jeweiligen Code vorgegebenen Position in der Wand (200, 300, 300a) und und/oder
   - bestimmungsgemäßes Anordnen der Vielzahl Bauelemente (100, 110, 120, 130, 140, 150, 160.... ) auf einer angepassten Gründung in einer durch den Code bestimmten Reihenfolge, beispielsweise auf einem Fundament und optionales Fixieren zueinander benachbarter Bauelemente (100, 110, 120, 130, 140, 150, 160....) mit einem Adhäsiv.
15. **Bauelement** (100, 110, 120, 130, 140, 150, 160....) zum Aufbau einer Wand (200, 300, 300a), umfassend eine untere Stellfläche (10), eine der unteren Stellfläche (10) im Wesentlichen parallel gegenüberliegende obere Anschlussfläche (11), sowie eine Seitenfläche (12, 13, 14, 15), die eine äußere Kontur (x₁₀, y₁₀) der unteren Stellfläche (10) mit einer äußeren Kontur der oberen Anschlussfläche (x₁₁, y₁₁) in einer im Wesentlichen vertikalen Richtung (z) miteinander verbindet, wobei das Bauelement eine Markierung aufweist, in der die Position des Bauelements in der Wand kodiert ist, wobei typischerweise zumindest zwei oder sogar zumindest drei in der Wand (200, 300, 300a) benachbarte Bauelemente (100, 110, 120, 130, 140, 150, 160....) zumindest einen Abschnitt eines in der Wand (200, 300, 300a) angeordneten Installationskanals (1) ausbilden.
16. Bauelement (100, 110, 120, 130, 140, 150, 160....) nach Ausführungsform 15, wobei der Abschnitt des Installationskanals (1) zumindest zwei Öffnungen umfasst und eine Ebene einer ersten Querschnittsendfläche (1b) des Abschnitts des Installationskanals (1) im Wesentlichen parallel oder im Wesentlichen orthogonal zu einer Ebene einer zweiten Querschnittsendfläche (1b) des Abschnitts des Installationskanals (1) orientiert ist.
17. Bauelement (100, 110, 120, 130, 140, 150, 160....) nach Ausführungsform 15 oder 16, wobei das Bauelement (100, 110, 120, 130, 140, 150, 160....) im Wesentlichen quaderförmig und vorzugsweise flächenfüllend ist und/oder an einander gegenüberliegenden Seiten Verankerungsstrukturen (25.1, 25.2) aufweist, die durch ihre jeweilige Größe, Form und Position individuell abhängig von ihrer Position in der Wand (200, 300, 300a) so konfiguriert sind, dass zumindest abschnittsweise ein Eingriff ausbildbar ist einer ersten Verankerungsstruktur (25.1) eines ersten Bauelements (100, 110, 120, 130, 140, 150, 160....) mit einer zweiten Verankerungsstruktur (25.2) eines in der Wand (200, 300, 300a) benachbarten zweiten Bauelements (100, 110, 120, 130, 140, 150, 160....) und einer Verankerungsstruktur (25.1, 25.2) eines in der Wand benachbarten dritten Bauelements (100, 110, 120, 130, 140, 150, 160....).
18. Bauelement (100, 110, 120, 130, 140, 150, 160....) nach einer der Ausführungsformen 15 bis 17,
   wobei eine Orientierung des Installationskanals (1) zumindest abschnittsweise von einer zur unteren Stellfläche (10) orthogonalen Orientierung abweicht.
19. Bauelement (100, 110, 120, 130, 140, 150, 160....) nach einer der Ausführungsformen 15 bis 18,
   wobei eine erste Öffnung (1b) des Installationskanals (1) an einer Seitenfläche (14, 15) des Bauelements (100, 110, 120, 130, 140, 150, 160....) angeordnet ist, und die zweite Kanalöffnung (1b) an der unteren Stellfläche (10) oder an der oberen Anschlussfläche (11) angeordnet ist.
20. Bauelement (100, 110, 120, 130, 140, 150, 160....) nach einer der Ausführungsformen 15 bis 19,
   wobei der Installationskanalabschnitt (1) in einem konstanten Abstand zu einer inneren oder einer äußeren Seitenfläche (10, 11, 12, 13, 14, 15) bzw. Mantelfläche des Bauelements (100, 110, 120, 130, 140, 150, 160....) verläuft.
21. Bauelement (100, 110, 120, 130, 140, 150, 160....) nach einer der Ausführungsformen 15 bis 20,
   wobei eine Querschnittsfläche des Installationskanalabschnitts (1) eine geometrische Fläche ist, ausgewählt unter einem Kreis, einer Ellipse, einem Dreieck, einem Rechteck, einem Quadrat, einem Trapez, einem Trapezoid, einem Stern und einem Polygon,
22. Bauelement (100, 110, 120, 130, 140, 150, 160....) nach einer der Ausführungsformen 15 bis 21,
   wobei der Installationskanalabschnitt (1) im Bauelement als freitragende Struktur vorliegt und eine Installationskanalwandung zumindest abschnittsweise benachbart ist zu einem Hohlraum des Bauelementes (100, 110, 120, 130, 140, 150, 160... )
23. Bauelement (100, 110, 120, 130, 140, 150, 160....) nach einer der Ausführungsformen 15 bis 22,
   wobei der Abschnitt des Installationskanals (1) in eine Öffnung für einen Schalter, eine Steckdose, ein Ventil, oder für eine Verteilerdose einmündet, diese umfasst und/oder einen Teil der Öffnung bilden.
24. **Bausatz** (4000) zum Aufbau einer Wand (200, 300, 300a) umfassend einen Installationskanal (1), umfassend eine Vielzahl Bauelemente (100, 110, 120, 130, 140, 150, 160....) gemäß eines der Ausführungsformen 15 bis 22, die konfiguriert sind, bei einer projektierten Anordnung in der Wand (200, 300, 300a) einen Abschnitt des Installationskanals (1) auszubilden.
25. **Gebäuderohbau** (3000), umfassend zumindest eine Wand (200, 300, 300a) aufgebaut aus einer Vielzahl Bauelemente (100, 110, 120, 130, 140, 150, 160....), die hergestellt sind nach einem Verfahren (1000) der Ausführungsformen 1-14; umfassend Bauelemente (100, 110, 120, 130, 140, 150, 160....) gemäß einer der Ausführungsformen 15 bis 22 und/oder einen Bausatz (4000) gemäß Ausführungsform 24.

## Patentansprüche

1. Verfahren (1000) zur Herstellung einer Wand (200, 300, 3000a), aufweisend die Prozesse:
- computergestütztes Konstruieren (1010) der Wand (200, 300, 300a), wobei die Wand (200, 300, 300a) einen Installationskanal (1) aufweist,
- computergestütztes Zerlegen (1020) der konstruierten Wand (200, 300, 300a) in Bauelemente (100, 110, 120, 130, 140, 150, 160....),
wobei eine Vielzahl zueinander benachbarter Bauelemente (100, 110, 120, 130, 140, 150, 160....) zumindest einen Abschnitt des Installationskanals (1) umfasst;
- computergestütztes Erstellen (1030) eines Steuerdatensatzes zur Steuerung einer Vorrichtung (500) zur additiven Fertigung, die konfiguriert ist, aus zumindest einem Baustoff die Vielzahl der Bauelemente (100, 110, 120, 130, 140, 150, 160....) individuell bereitzustellen;
- additives Fertigen (1040) der Vielzahl der Bauelemente (100, 110, 120, 130, 140, 150, 160....) für die Wand (200, 300, 300a) mit der Vorrichtung (500) zur additiven Fertigung unter Verwendung des Steuerdatensatzes; und typischerweise
- Errichten der Wand (1100) durch ein geordnetes Fügen der Vielzahl der gefertigten Bauelemente (100, 110, 120, 130, 140, 150, 160....) umfassend ein Ausbilden eines Verbandes (200, 300, 300a) der Bauelemente 100, 110, 120, 130, 140, 150, 160....).

2. Verfahren (1000) nach Anspruch 1, wobei das computergestützte Zerlegen (1020) der konstruierten Wand (200, 300, 300a) in Bauelemente (100, 110, 120, 130, 140, 150, 160....) schichtweise in zueinander benachbarte Schichten erfolgt, und ein anschließendes Aufteilen (1025) jeder dieser Schichten in eine Abfolge von Bauelementen (100, 110, 120, 130, 140, 150, 160....), umfassend die Vielzahl benachbarter Bauelemente (100, 110, 120, 130, 140, 150, 160....) umfasst;
wobei das computergestütztes Zerlegen (1020) der konstruierten Wand (200, 300, 300a) in die Bauelemente (100, 110, 120, 130, 140, 150, 160....) so erfolgt, dass deren jeweilige Masse zwischen 1 kg und 25 kg, bevorzugt zwischen 5 kg und 10 kg beträgt, und
wobei optional das Aufteilen (1025) der zueinander benachbarten Schichten in Bauelemente (100, 110, 120, 130, 140, 150, 160....) so erfolgt, dass im Wesentlichen vertikal angeordnete Flächen (14, 15) der Bauelemente (100, 110, 120, 130, 140, 150, 160....) benachbarter Schichten, die eine Wandfläche ausbilden, versetzt zueinander verlaufen.

3. Verfahren (1000) nach einem der vorstehenden Ansprüche, wobei das computergestützte Erstellen (1030) des Steuerdatensatzes und das additive Fertigen (1040) angepasst sind, den Abschnitt des Installationskanals (1) mit zumindest zwei Öffnungen zu versehen, wobei eine Ebene einer ersten Querschnittsendfläche des Abschnitts des Installationskanals (1) im Wesentlichen parallel oder im Wesentlichen orthogonal zu einer Ebene einer zweiten Querschnittsendfläche des Abschnitts des Installationskanals (1) des gefertigten Bauelements (100, 110, 120, 130, 140, 150, 160....) orientiert ist.

4. Verfahren (1000) nach einem der vorstehenden Ansprüche
- wobei beim Ausbilden des Verbandes (1100) benachbarte Bauelemente (100, 110, 120, 130, 140, 150, 160...) mit einem Adhäsiv fixiert werden, und
- wobei der Installationskanal (1) konfiguriert ist für eine Installation eines Kabels, eines Rohres und/oder für den Transport eines Fluids.

5. Verfahren (1000) nach einem der vorstehenden Ansprüche,
wobei die gefertigten Bauelemente (100, 110, 120, 130, 140, 150, 160....) im Wesentlichen quaderförmig sind und/oder sich auf eine oder mehrere quaderförmige Grundformen zurückführen lassen, und die gefertigten Bauelemente (100, 110, 120, 130, 140, 150, 160....) typischerweise an einander gegenüberliegenden Seiten Verankerungsstrukturen (25.1, 25.2) aufweisen, die durch ihre jeweilige Größe, Form und Position so konfiguriert sind, dass zumindest abschnittsweise ein Eingriff ausbildbar ist einer ersten Verankerungsstruktur (25.1) eines ersten Bauelements (100, 110, 120, 130, 140, 150, 160....) mit einer zweiten Verankerungsstruktur (25.2) eines in der Wand (200, 300, 300a) benachbarten zweiten Bauelements (100, 110, 120, 130, 140, 150, 160....).

6. Verfahren (1000) nach einem der vorstehenden Ansprüche, weiter aufweisend:
- individuelles Verpacken (1070) aller oder zumindest der Vielzahl der Bauelemente (100, 110, 120, 130, 140, 150, 160.... ) mit einem Verpackungsmaterial.

7. Verfahren (1000) nach einem der vorstehenden Ansprüche, weiter aufweisend:
- Markieren (1200) der Bauelemente (100, 110, 120, 130, 140, 150, 160....) mit einem ihre jeweilige Position in der Wand (200, 300, 300a) kennzeichnenden individuellen Code.

8. Verfahren (1000) nach einem der vorstehenden Ansprüche,
wobei das additive Fertigen (1040) mit einem Baustoff erfolgt, umfassend: einen Beton, einen Mörtel, einen Lehm, einen Ton, ein Alumosilikat, eine kieselsäurehaltige Verbindung, ein Metakaolin, ein organisches Polymer, ein vernetzungsfähiges Monomer, ein Puzzolan und/oder ein zu einer Geopolymerbildung geeignetes Materialgemisch; und .
wobei bei dem additiven Fertigen (1040) in den Bauelementen (100, 110, 120, 130, 140, 150, 160.... ) ein Gradient einer relativen Konzentration einer Baustoffart, einer Baustoffdichte, einer Porosität, einer Pigmentierung, einer Benetzbarkeit, einer Wärmeleitfähigkeit, und/oder einer Schalldämmwirkung erzeugt wird, wobei der Gradient im Wesentlichen orthogonal zu einer Fläche der Wand (200, 300, 300a) orientiert ist.

9. Verfahren (1000) nach einem der Ansprüche 7 oder 8, weiter aufweisend die Prozesse:
- automatisches Aufnehmen und Anordnen der Vielzahl Bauelemente (100, 110, 120, 130, 140, 150, 160....) auf einem Transportmittel;
- Transportieren (1090) der auf dem Transportmittel angeordneten Vielzahl Bauelemente (100, 110, 120, 130, 140, 150, 160....) zu einer Baustelle;
- Entladen des Transportmittels umfassend ein geordnetes Absetzen der Vielzahl Bauelemente (100, 110, 120, 130, 140, 150, 160....) auf einer Lagerfläche entsprechend ihrer durch den jeweiligen Code vorgegebenen Position in der Wand (200, 300, 300a) und und/oder
- bestimmungsgemäßes Anordnen der Vielzahl Bauelemente (100, 110, 120, 130, 140, 150, 160.... ) auf einer angepassten Gründung in einer durch den Code bestimmten Reihenfolge, beispielsweise auf einem Fundament und optionales Fixieren zueinander benachbarter Bauelemente (100, 110, 120, 130, 140, 150, 160....) mit einem Adhäsiv.

10. Bauelement (100, 110, 120, 130, 140, 150, 160....) zum Aufbau einer Wand (200, 300, 300a), umfassend eine untere Stellfläche (10), eine der unteren Stellfläche (10) im Wesentlichen parallel gegenüberliegende obere Anschlussfläche (11), sowie eine Seitenfläche (12, 13, 14, 15), die eine äußere Kontur (x₁₀, y₁₀) der unteren Stellfläche (10) mit einer äußeren Kontur der oberen Anschlussfläche (x₁₁, y₁₁) in einer im Wesentlichen vertikalen Richtung (z) miteinander verbindet, wobei das Bauelement eine Markierung aufweist, in der die Position des Bauelements in der Wand kodiert ist, wobei typischerweise zumindest zwei oder sogar zumindest drei in der Wand (200, 300, 300a) benachbarte Bauelemente (100, 110, 120, 130, 140, 150, 160....) zumindest einen Abschnitt eines in der Wand (200, 300, 300a) angeordneten Installationskanals (1) ausbilden.

11. Bauelement (100, 110, 120, 130, 140, 150, 160....) nach Anspruch 10, wobei das Bauelement (100, 110, 120, 130, 140, 150, 160....) im Wesentlichen quaderförmig und vorzugsweise flächenfüllend ist und/oder an einander gegenüberliegenden Seiten Verankerungsstrukturen (25.1, 25.2) aufweist, die durch ihre jeweilige Größe, Form und Position individuell abhängig von ihrer Position in der Wand (200, 300, 300a) so konfiguriert sind, dass zumindest abschnittsweise ein Eingriff ausbildbar ist einer ersten Verankerungsstruktur (25.1) eines ersten Bauelements (100, 110, 120, 130, 140, 150, 160....) mit einer zweiten Verankerungsstruktur (25.2) eines in der Wand (200, 300, 300a) benachbarten zweiten Bauelements (100, 110, 120, 130, 140, 150, 160....) und einer Verankerungsstruktur (25.1, 25.2) eines in der Wand benachbarten dritten Bauelements (100, 110, 120, 130, 140, 150, 160....).

12. Bauelement (100, 110, 120, 130, 140, 150, 160....) nach einem der Ansprüche 10 oder 11,
wobei eine Orientierung des Installationskanals (1) zumindest abschnittsweise von einer zur unteren Stellfläche (10) orthogonalen Orientierung abweicht; und
wobei optional eine erste Öffnung (1b) des Installationskanals (1) an einer Seitenfläche (14, 15) des Bauelements (100, 110, 120, 130, 140, 150, 160....) angeordnet ist, und die zweite Kanalöffnung (1b) an der unteren Stellfläche (10) oder an der oberen Anschlussfläche (11) angeordnet ist.

13. Bauelement (100, 110, 120, 130, 140, 150, 160....) nach einem der Ansprüche 10 bis 12,
wobei der Installationskanalabschnitt (1) in einem konstanten Abstand zu einer inneren oder einer äußeren Seitenfläche (10, 11, 12, 13, 14, 15) bzw. Mantelfläche des Bauelements (100, 110, 120, 130, 140, 150, 160....) verläuft.

14. Bausatz (4000) zum Aufbau einer Wand (200, 300, 300a) umfassend einen Installationskanal (1), umfassend eine Vielzahl Bauelemente (100, 110, 120, 130, 140, 150, 160....) gemäß eines der Ansprüche 10 bis 13, die konfiguriert sind, bei einer projektierten Anordnung in der Wand (200, 300, 300a) einen Abschnitt des Installationskanals (1) auszubilden.

15. Gebäuderohbau (3000), umfassend zumindest eine Wand (200, 300, 300a) aufgebaut aus einer Vielzahl Bauelemente (100, 110, 120, 130, 140, 150, 160....), die hergestellt sind nach einem Verfahren (1000) der Ansprüche 1-9; umfassend Bauelemente (100, 110, 120, 130, 140, 150, 160....) gemäß einem der Ansprüche 10 bis 13 und/oder einen Bausatz (4000) gemäß Anspruch 14.
